# EUROPEAN PATENT APPLICATION

(11) **EP 4 531 085 A1**
(43) Date of publication of application: **02.04.2025**
(21) Application number: 24191001.7
(22) Date of filing: 25.07.2024
(51) Int. Cl.: H01L 21/768, H01L 23/528, H01L 23/535

(54) **SEMICONDUCTOR DEVICES INCLUDING BACKSIDE POWER DELIVERY**

(30) Priority: 27.09.2023 KR 20230130091
(71) Applicant: SAMSUNG ELECTRONICS CO., LTD., Yeongtong-gu Suwon-si, Gyeonggi-do 16677 (KR)
(72) Inventor: LEE, Jin Myoung, 16677 Suwon-si (KR); LEE, Kyen-Hee, 16677 Suwon-si (KR)
(74) Representative: Marks & Clerk LLP

(57) **Abstract**

A semiconductor device includes a backside power delivery network (BSPDN). The semiconductor device includes a substrate, a first active pattern extending in a first direction, on a top surface of the substrate, a second active pattern extending in the first direction, and spaced apart from the first active pattern in a second direction intersecting the first direction, on the top surface of the substrate, a gate structure extending in the second direction, on the first active pattern and the second active pattern, a first source/drain pattern connected to the first active pattern, on a side surface of the gate structure, a second source/drain pattern connected to the second active pattern, on the side surface of the gate structure, back source/drain contacts penetrating the substrate, and a first power line connected to the back source/drain contacts on a bottom surface of the substrate.

## Description

### BACKGROUND

The present disclosure relates to semiconductor devices including backside power delivery.

Semiconductor devices include, for example, semiconductor memory devices for storing logic data, semiconductor logic devices for processing computation of logic data, hybrid semiconductor devices including a storage element and a logic element, and the like. Demands for high reliability, high speed and/or multifunctionality, and the like for semiconductor devices are increasing. In order to meet these demands, structures in semiconductor devices are becoming increasingly complex and highly integrated. As semiconductor devices become more highly integrated, the widths of wiring patterns and via patterns that implement semiconductor devices are decreasing.

### SUMMARY

Aspects of the present disclosure provide semiconductor devices with improved power, performance, area, cost (PPAC).

Aspects of the present disclosure also provide a method for fabricating semiconductor devices with improved PPAC.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to some aspects of the present disclosure, there is provided a semiconductor device comprising a substrate, a first active pattern extending in a first direction, on a top surface of the substrate, a second active pattern extending in the first direction, and spaced apart from the first active pattern in a second direction intersecting the first direction, on the top surface of the substrate, a gate structure extending in the second direction, on the first active pattern and the second active pattern, a first source/drain pattern connected to the first active pattern, on a side surface of the gate structure, a second source/drain pattern connected to the second active pattern, on the side surface of the gate structure, a first back source/drain contact penetrating the substrate to be connected to the first source/drain pattern, a second back source/drain contact penetrating the substrate to be connected to the second source/drain pattern, and spaced apart from the first back source/drain contact in the second direction, and a first power line extending in the first direction, and connected to the first back source/drain contact and the second back source/drain contact, on a bottom surface of the substrate, wherein the first back source/drain contact comprises a first side surface facing the second back source/drain contact and a second side surface opposite to the first side surface, the second back source/drain contact comprises a third side surface facing the first back source/drain contact and a fourth side surface opposite to the third side surface, with respect to the bottom surface of the substrate, the second side surface and the fourth side surface are spaced apart from each other by a first distance in the second direction, and with respect to a bottom surface of the first power line, at least a part of the first power line has a first width smaller than the first distance in the second direction.

According to some aspects of the present disclosure, there is provided a semiconductor device comprising a first base pattern extending in a first direction, a second base pattern extending in the first direction, and spaced apart from the first base pattern in a second direction intersecting the first direction, a first active pattern extending in the first direction, on a top surface of the first base pattern, a second active pattern extending in the first direction, on a top surface of the second base pattern, a gate structure extending in the second direction, on the first active pattern and the second active pattern, a first source/drain pattern connected to the first active pattern, on a side surface of the gate structure, a second source/drain pattern connected to the second active pattern, on the side surface of the gate structure, a first back source/drain contact connected to the first source/drain pattern, in the first base pattern, a second back source/drain contact connected to the second source/drain pattern, in the second base pattern, and a first power line extending in the first direction, and connected to the first back source/drain contact and the second back source/drain contact, on a bottom surface of the first base pattern and a bottom surface of the second base pattern, wherein the first base pattern comprises a first side surface facing the second base pattern and a second side surface opposite to the first side surface, the second base pattern comprises a third side surface facing the first base pattern and a fourth side surface opposite to the third side surface, with respect to the bottom surface of the first base pattern, the second side surface and the fourth side surface are spaced apart from each other by a first distance in the second direction, and with respect to a bottom surface of the first power line, at least a part of the first power line has a first width smaller than the first distance in the second direction.

According to some aspects of the present disclosure, there is provided a semiconductor device comprising a substrate, first to third active patterns each extending in a first direction, and sequentially arranged along a second direction intersecting the first direction, on a top surface of the substrate, a gate structure extending in the second direction, the first to third active patterns each penetrating the gate structure, a first back source/drain contact penetrating the substrate to be connected to a first source/drain pattern of the first active pattern, a second back source/drain contact penetrating the substrate to be connected to a second source/drain pattern of the second active pattern, a third back source/drain contact penetrating the substrate to be connected to a third source/drain pattern of the third active pattern, a first power line extending in the first direction, connected to the first back source/drain contact and the second back source/drain contact, and to which a first power voltage is applied, on a bottom surface of the substrate, and a second power line extending in the first direction, connected to the third back source/drain contact, and to which a second power voltage different from the first power voltage is applied, on the bottom surface of the substrate, wherein the first back source/drain contact comprises a first side surface facing the second back source/drain contact and a second side surface opposite to the first side surface, the second back source/drain contact comprises a third side surface facing the first back source/drain contact and a fourth side surface opposite to the third side surface, with respect to the bottom surface of the substrate, the second side surface and the fourth side surface are spaced apart from each other by a first distance in the second direction, and with respect to a bottom surface of the first power line, at least a part of the first power line has a first width smaller than the first distance in the second direction.

At least some of the above and other features of the invention are set out in the claims.

### BRIEF DESCRIPTION OF THE DRAWINGS

The above and other aspects and features of the present disclosure will become more apparent by describing in detail examples thereof with reference to the attached drawings, in which:
FIG. 1 is a layout diagram illustrating a semiconductor device according to some implementations.
FIG. 2 is a schematic cross-sectional view taken along line A-A of FIG. 1.
FIG. 3 is a schematic cross-sectional view taken along line B-B of FIG. 1.
FIG. 4 is an enlarged view illustrating region R1 of FIG. 3.
FIG. 5 is a schematic cross-sectional view taken along line C-C of FIG. 1.
FIG. 6 is an enlarged view illustrating region R2 of FIG. 5.
FIG. 7 is a schematic cross-sectional view taken along line D-D of FIG. 1.
FIG. 8 is a schematic cross-sectional view illustrating a semiconductor device according to some implementations.
FIG. 9 is an enlarged view illustrating region R3 of FIG. 8.
FIG. 10 is a schematic cross-sectional view illustrating a semiconductor device according to some implementations.
FIG. 11 is an enlarged view illustrating region R4 of FIG. 10.
FIG. 12 is a layout diagram illustrating a semiconductor device according to some implementations.
FIG. 13 is a schematic cross-sectional view taken along line E-E of FIG. 12.
FIG. 14 is a layout diagram illustrating a semiconductor device according to some implementations.
FIG. 15 is a schematic cross-sectional view taken along line F-F of FIG. 14.
FIG. 16 is a layout diagram illustrating a semiconductor device according to some implementations.
FIG. 17 is a schematic cross-sectional view taken along line G-G of FIG. 16.
FIG. 18 is a layout diagram illustrating a semiconductor device according to some implementations.
FIG. 19 is a schematic cross-sectional view taken along line H-H of FIG. 18.
FIGS. 20A to 21B are layout diagrams illustrating a semiconductor device according to some implementations.
FIGS. 22 to 39 are views illustrating the intermediate steps of a method for fabricating a semiconductor device according to some implementations.

### DETAILED DESCRIPTION

Although the terms first, second, etc. may be used herein to describe various elements or components, these elements or components should not be limited by these terms. These terms are used to distinguish one element or component from another element or component. Thus, a first element or component discussed below could be termed a second element or component without departing from the teachings of the present disclosure.

Reduced widths of wiring patterns and via patterns may be associated with increased voltage drops of power delivery networks (PDN). For example, the "IR" drop for power voltages to integrated circuits may increase. Aspects of this disclosure provide semiconductor devices, systems, and methods that can provide improved power, performance, area, and/or cost in this context.

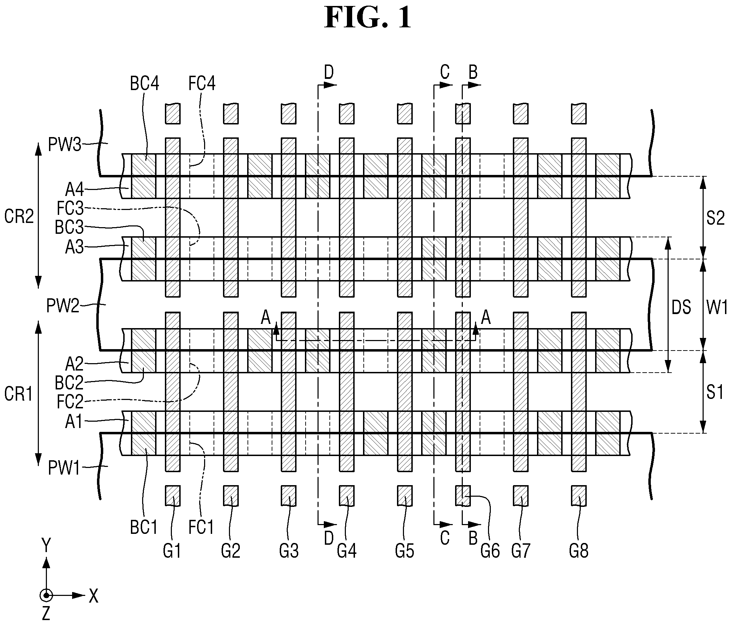

Hereinafter, a semiconductor device according to some implementations will be described with reference to FIGS. 1 to 22.

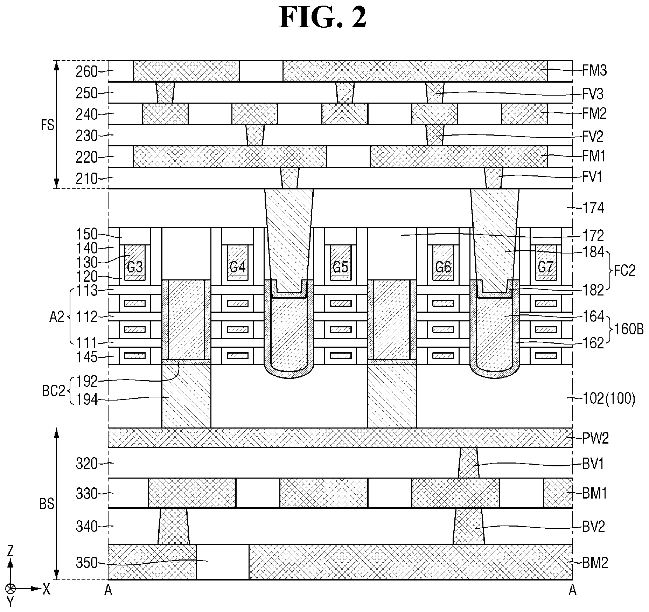

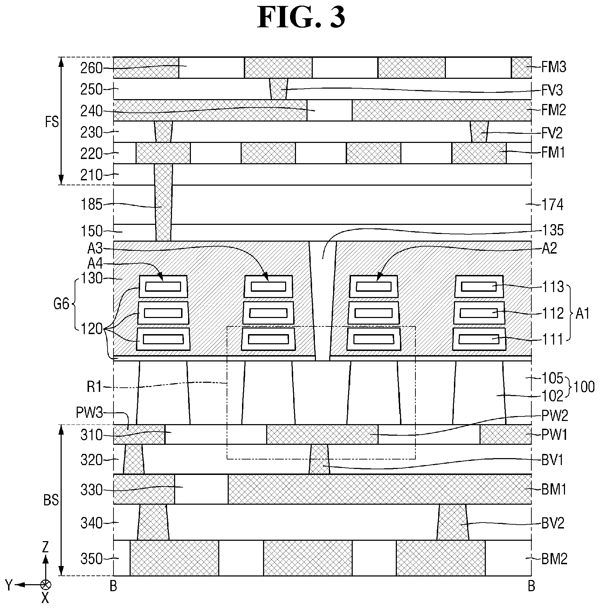

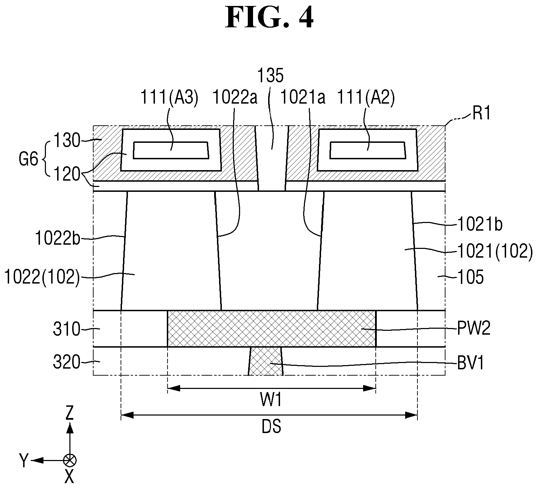

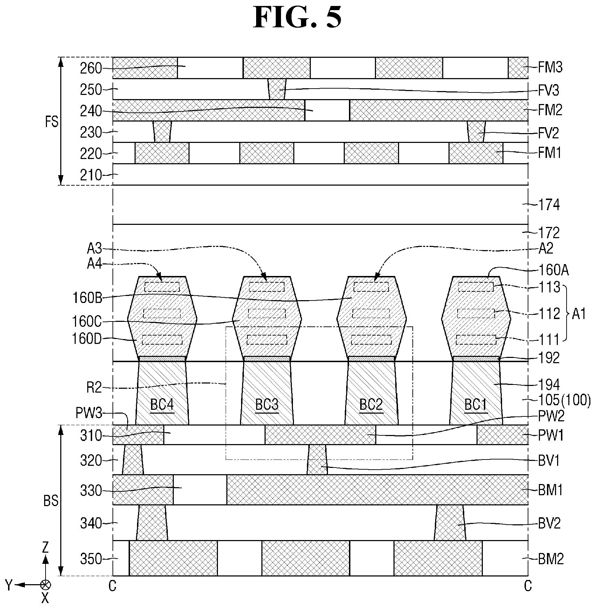

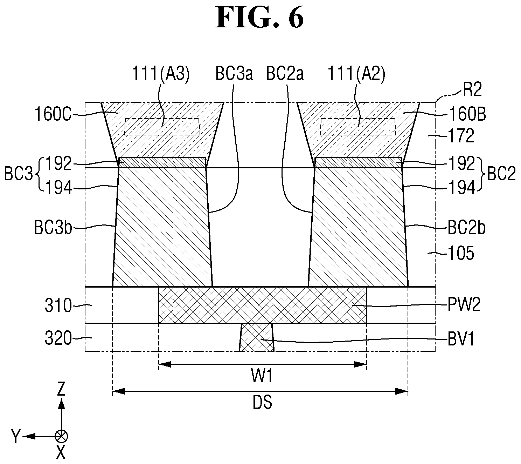

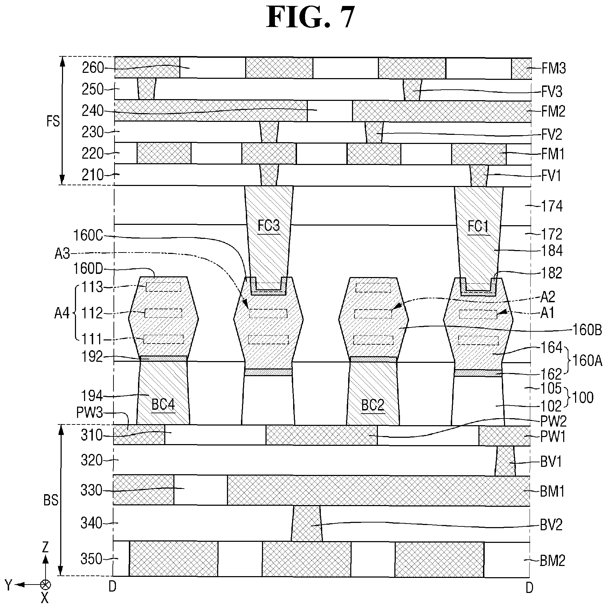

FIG. 1 is a layout diagram illustrating a semiconductor device according to some implementations. FIG. 2 is a schematic cross-sectional view taken along line A-A of FIG. 1. FIG. 3 is a schematic cross-sectional view taken along line B-B of FIG. 1. FIG. 4 is an enlarged view illustrating region R1 of FIG. 3. FIG. 5 is a schematic cross-sectional view taken along line C-C of FIG. 1. FIG. 6 is an enlarged view illustrating region R2 of FIG. 5. FIG. 7 is a schematic cross-sectional view taken along line D-D of FIG. 1.

Referring to FIGS. 1 to 7, a semiconductor device according to some implementations includes a substrate 100, a plurality of active patterns A1 to A4, a plurality of gate structures G1 to G8, a plurality of source/drain patterns 160A to 160D (shown in FIG. 5), a first interlayer insulating layer 172, a second interlayer insulating layer 174, a plurality of front source/drain contacts FC1 to FC4, a front wiring structure FS, a plurality of back source/drain contacts BC1 to BC4, and a back wiring structure BS.

The substrate 100 may include a top surface and a bottom surface opposite to each other. In this specification, the top surface of the substrate 100 may also be referred to as a frontside, and the bottom surface of the substrate 100 may also be referred to as a backside.

The substrate 100 may include a first cell region CR1 and a second cell region CR2 that are adjacent to each other. For example, the first cell region CR1 and the second cell region CR2 may each extend in a first direction X and may be arranged along a second direction Y that intersects the first direction X (e.g., is orthogonal to the first direction x). At least one integrated circuit may be provided in each of the first cell region CR1 and the second cell region CR2. The integrated circuit provided in the first cell region CR1 and the second cell region CR2 may include various logic elements such as an inverter, an AND gate, an OR gate, an NAND gate, an NOR gate, and an XOR gate, or a static random access memory (SRAM) device, but is not limited thereto.

In some implementations, the substrate 100 may include an insulating material. For example, the substrate 100 may be an insulating substrate including at least one of silicon oxide, silicon oxynitride, silicon oxycarbonitride, or a combination thereof.

In some implementations, the substrate 100 may include a plurality of base patterns 102 and a field insulating layer 105.

The base patterns 102 may extend side by side while being spaced apart from each other. For example, the base patterns 102 may each extend in the first direction X, and may be spaced apart from each other in the second direction Y. In some implementations, each of the base patterns 102 may include an insulating material. For example, each of the base pattern 102 may include at least one of silicon oxide, silicon nitride, silicon oxycarbide, silicon oxynitride, silicon oxycarbonitride, or a combination thereof, but the present disclosure is not limited thereto.

The field insulating layer 105 may cover at least a part of the side surface of each of the base patterns 102. For example, the field insulating layer 105 may fill the space between the base patterns 102. The field insulating layer 105 may include, for example, at least one of silicon oxide, silicon nitride, silicon oxycarbide, silicon oxynitride, silicon oxycarbonitride, or a combination thereof, but is not limited thereto. The field insulating layer 105 may include the same material as those of the base patterns 102, or may include a material different from those of the base patterns 102. In some implementations, the bottom surface of the field insulating layer 105 may be disposed on the same plane as the bottom surfaces of the base patterns 102. In some implementations, the top surface of the field insulating layer 105 may be disposed on the same plane as the top surfaces of the base patterns 102.

The plurality of active patterns A1 to A4 may be disposed on the top surface of the substrate 100. The active patterns A1 to A4 may extend side by side while being spaced apart from each other. For example, the active patterns A1 to A4 may include the first active pattern A1, the second active pattern A2, the third active pattern A3, and the fourth active pattern A4 that are sequentially arranged along the second direction Y. The active patterns A1 to A4 may each extend in the first direction X, and may be spaced apart from each other in the second direction Y. The first active pattern A1 and the second active pattern A2 may be disposed on the first cell region CR1, and the third active pattern A3 and the fourth active pattern A4 may be disposed on the second cell region CR2.

Each of the active patterns A1 to A4 may include silicon (Si) or germanium (Ge), each of which is an elemental semiconductor material. For example, each of the active patterns A1 to A4 may include a silicon pattern. Each of the active patterns A1 to A4 may include a compound semiconductor, for example, a group IV-IV compound semiconductor or a group III-V compound semiconductor. The group IV-IV compound semiconductor may be a binary compound or a ternary compound including at least two elements selected from the group consisting of carbon (C), silicon (Si), germanium (Ge) and tin (Sn), or the above-mentioned compound doped with a group IV element. The group III-V compound semiconductor may be, for example, a binary compound, a ternary compound or a quaternary compound formed by combining at least one of aluminum (Al), gallium (Ga) and indium (In) which are group III elements with at least one of phosphorus (P), arsenic (As) and antimony (Sb) which are group V elements.

In some implementations, the active patterns A1 to A4 may be disposed on the top surfaces of the base patterns 102. For example, the active patterns A1 to A4 and the base patterns 102 may overlap in a third direction Z that intersects the top surface of the substrate 100.

In some implementations, each of the active patterns A1 to A4 may include a plurality of bridge patterns (for example, first to third bridge patterns 111 to 113) that are sequentially stacked on the base patterns 102 and spaced apart from each other. These active patterns A1 to A4 may be used as a channel region of a multibridge-channel metal-oxide-semiconductor field-effect transistor (MBCFET^{®}) including a multi-bridge channel. The number of bridge patterns included in each of the active patterns A1 to A4 is only an example and is not limited thereto.

The plurality of gate structures G1 to G8 may be disposed on the substrate 100 and the active patterns A1 to A4. The gate structures G1 to G8 may extend side by side while being spaced apart from each other. Further, the gate structures G1 to G8 may intersect the active patterns A1 to A4. For example, the gate structures G1 to G8 may elongate in the second direction Y, and may be spaced apart from each other in the first direction X.

In some implementations, the active patterns A1 to A4 penetrate the gate structures G1 to G8 while extending in the first direction X. For example, the bridge patterns 111 to 113 may penetrate the gate structures G1 to G8 while extending in the first direction X. The gate structures G1 to G8 may surround the perimeters of the bridge pattern 111 to 113.

Each of the gate structures G1 to G8 (shown, for example, for G6 in FIG. 3) may include a gate dielectric layer 120 and a gate electrode 130. The gate dielectric layer 120 and the gate electrode 130 may be sequentially stacked on the active patterns A1 to A4.

The gate dielectric layer 120 may be formed on each of the active patterns A1 to A4. The gate dielectric layer 120 may be interposed between each of the active patterns A1 to A4 and the gate electrode 130. For example, the gate dielectric layer 120 may surround the perimeters of the active patterns A1 to A4. In some implementations, the gate dielectric layer 120 may extend conformally along the perimeters of the bridge patterns 111 to 113.

The gate dielectric layer 120 may include, for example, at least one of silicon oxide, silicon oxynitride, silicon nitride, or a high-k material having a higher dielectric constant than silicon oxide. The high-k material may include, for example, at least one of hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓNy), or combinations thereof, but is not limited thereto.

The semiconductor device according to some implementations may include a negative capacitor (NC) FET using a negative capacitor (NC). For example, the gate dielectric layer 120 may include a ferroelectric material layer having ferroelectric properties and a paraelectric material layer having paraelectric properties.

The ferroelectric material layer may have a negative capacitance, and the paraelectric material layer may have a positive capacitance. For example, when two or more capacitors are connected in series and the capacitance of each capacitor has a positive value, the total capacitance becomes smaller than the capacitance of each capacitor. On the other hand, when at least one of the capacitances of two or more capacitors connected in series has a negative value, the total capacitance may have a positive value and may be greater than the absolute value of each capacitance.

When a ferroelectric material layer having a negative capacitance and a paraelectric material layer having a positive capacitance are connected in series, the total capacitance value of the ferroelectric material layer and the paraelectric material layer connected in series may increase. By using an increase in the total capacitance value, the transistor including the ferroelectric material layer may have a subthreshold swing (SS) less than about 60 mV/decade at room temperature.

The ferroelectric material layer may have ferroelectric properties. The ferroelectric material layer may include, for example, at least one of hafnium oxide, hafnium zirconium oxide, barium strontium titanium oxide, barium titanium oxide, or lead zirconium titanium oxide. In this case, as one example, the hafnium zirconium oxide may be a material containing hafnium oxide doped with zirconium (Zr). As another example, the hafnium zirconium oxide may be a compound of hafnium (Hf), zirconium (Zr), and oxygen (O).

The ferroelectric material layer may further include a dopant doped therein. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). The type of dopant included in the ferroelectric material layer may vary depending on which ferroelectric material is included in the ferroelectric material layer.

When the ferroelectric material layer includes hafnium oxide, the dopant included in the ferroelectric material layer may include, for example, at least one of gadolinium (Gd), silicon (Si), zirconium (Zr), aluminum (Al), or yttrium (Y).

When the dopant is aluminum (Al), the ferroelectric material layer may include about 3 atomic percent (at%) to about 8 at% of aluminum. In this case, the ratio of the dopant may be a ratio of aluminum to the sum of hafnium and aluminum.

When the dopant is silicon (Si), the ferroelectric material layer may include about 2 at% to about 10 at% of silicon. When the dopant is yttrium (Y), the ferroelectric material layer may include 2 at% to 10 at% of yttrium. When the dopant is gadolinium (Gd), the ferroelectric material layer may include 1 at% to 7 at% of gadolinium. When the dopant is zirconium (Zr), the ferroelectric material layer may include 50 at% to 80 at% of zirconium.

The paraelectric material layer may have paraelectric properties. The paraelectric material layer may include, for example, at least one of silicon oxide or metal oxide having a high dielectric constant. The metal oxide included in the paraelectric material layer may include, for example, at least one of hafnium oxide, zirconium oxide, or aluminum oxide, but is not limited thereto.

The ferroelectric material layer and the paraelectric material layer may include the same material. The ferroelectric material layer may have ferroelectric properties, but the paraelectric material layer may not have ferroelectric properties. For example, when the ferroelectric material layer and the paraelectric material layer include hafnium oxide, the crystal structure of the hafnium oxide included in the ferroelectric material layer is different from the crystal structure of the hafnium oxide included in the paraelectric material layer.

The ferroelectric material layer may have a thickness that exhibits ferroelectric properties. The thickness of the ferroelectric material layer may be, for example, in a range of 0.5 nm to 10 nm, but is not limited thereto. Since a critical thickness at which each ferroelectric material exhibits ferroelectric properties may be different, the thickness of the ferroelectric material layer may vary depending on the ferroelectric material.

In one example, the gate dielectric layer 120 may include one ferroelectric material layer. In another example, the gate dielectric layer 120 may include a plurality of ferroelectric material layers spaced apart from each other. The gate dielectric layer 120 may have a laminated layer structure in which a plurality of ferroelectric material layers and a plurality of paraelectric material layers are alternately laminated.

The gate electrode 130 may be formed on the gate dielectric layer 120. The gate electrode 130 may be formed, for example, by a replacement process, but is not limited thereto.

Although the gate electrode 130 is illustrated as being a single layer, this is only an example, and the gate electrode 130 may be formed by stacking a plurality of conductive layers. For example, the gate electrode 130 may include a work function adjusting layer to adjust the work function and a filling conductive layer to fill a space formed by the work function adjusting layer. The work function adjusting layer may include at least one of TiN, TaN, TiC, TaC, TiAlC or a combination thereof, for example. The filling conductive layer may include, for example, W or Al.

In some implementations, a gate spacer 140 (shown in FIG. 2) may be formed on the side surface of each of the gate structures G1 to G8. The gate spacer 140 may be formed on the substrate 100. Further, the gate spacer 140 may extend along the side surface of the gate electrode 130. In some implementations, a part of the gate dielectric layer 120 may be interposed between the gate electrode 130 and the gate spacer 140. For example, the gate dielectric layer 120 may further extend along the inner side surface of the gate spacer 140. The gate dielectric layer 120 may be formed by a replacement process, but is not limited thereto.

The gate spacer 140 may include an insulating material, for example, at least one of silicon nitride, silicon oxynitride, silicon oxycarbide, silicon boron nitride, silicon boron carbonitride, silicon oxycarbonitride, or a combination thereof, but is not limited thereto. For example, the gate spacer 140 may include a silicon nitride layer.

In some implementations, a gate capping layer 150 may be formed on the top surface of each of the gate structures G1 to G8. The gate capping layer 150 may extend along the top surface of the gate electrode 130. Although it is illustrated in FIG. 2 that the top surface of the gate capping layer 150 is disposed on the same plane as the top surface of the gate spacer 140, this is only by way of example. For another example, the gate capping layer 150 may cover the top surface of the gate spacer 140.

The gate capping layer 150 may include an insulating material, for example, at least one of silicon nitride, silicon oxynitride, silicon oxycarbide, silicon boron nitride, silicon boron carbonitride, silicon oxycarbonitride, or a combination thereof, but is not limited thereto. For example, the gate capping layer 150 may include a silicon nitride layer.

In some implementations, a gate cutting pattern 135 that extends through/cuts the gate structures G1 to G8 may be formed. For example, the gate cutting pattern 135 may extend in the first direction X to extend through/cut the gate structures G1 to G8. In some implementations, at least a part of the gate cutting pattern 135 may be interposed between the second active pattern A2 and the third active pattern A3. The gate cutting pattern 135 may separate the gate structures G1 to G8 on the first cell region CR1 and the gate structures G1 to G8 on the second cell region CR2.

The gate cutting pattern 135 may include an insulating material, for example, at least one of silicon nitride (SiN), silicon oxynitride (SiON), silicon oxycarbonitride (SiOCN) or a combination thereof, but is not limited thereto.

The source/drain patterns 160A to 160D may be disposed on the side surfaces of the active patterns A1 to A4. Further, the source/drain patterns 160A to 160D may be disposed on at least one side surface (for example, both side surfaces) of each of the gate structures G1 to G8. The source/drain patterns 160A to 160D may be connected to the active patterns A1 to A4. For example, the source/drain patterns 160A to 160D may include the first source/drain pattern 160A connected to the first active pattern A1, the second source/drain pattern 160B connected to the second active pattern A2, the third source/drain pattern 160C connected to the third active pattern A3, and the fourth source/drain pattern 160D connected to the fourth active pattern A4.

In some implementations, the active patterns A1 to A4 may be connected to the source/drain patterns 160A to 160D while penetrating/extending through the gate structures G1 to G8. The source/drain patterns 160A to 160D may be electrically separated from the gate electrode 130 by the gate dielectric layer 120 and/or the gate spacer 140. The source/drain patterns 160A to 160D may be provided as source/drain regions of a field effect transistor including the active patterns A1 to A4 and the gate structures G1 to G8.

In some implementations, each of the source/drain patterns 160A to 160D may include an epitaxial layer. For example, the source/drain patterns 160A to 160D may be formed by an epitaxial growth process using the active patterns A1 to A4 as seed layers. Although it is illustrated in FIGS. 5 to 7 that the cross sections of the source/drain patterns 160A to 160D intersecting the first direction X are hexagonal, this is only by way of example. Depending on the conditions of the epitaxial growth process, the cross sections of the source/drain patterns 160A to 160D intersecting the first direction X may have various shapes, such as a pentagonal shape, a diamond shape, and the like.

When the field effect transistor including the active patterns A1 to A4 and the gate structures G1 to G8 is an NFET, the source/drain patterns 160A to 160D may contain n-type impurities or impurities for preventing diffusion of n-type impurities. For example, the source/drain patterns 160A to 160D may include at least one of P, Sb, As, or a combination thereof.

In some implementations, the source/drain patterns 160A to 160D may include a tensile stress material. For example, when the active patterns A1 to A4 are silicon (Si) patterns, the source/drain patterns 160A to 160D may include a material (for example, silicon carbide (SiC)) having a lattice constant smaller than that of silicon (Si). The tensile stress material may apply tensile stress to the active patterns A1 to A4 to improve carrier mobility in the channel region.

When the field effect transistor including the active patterns A1 to A4 and the gate structures G1 to G8 is a PFET, the source/drain patterns 160A to 160D may contain p-type impurities or impurities for preventing diffusion of p-type impurities. For example, the source/drain patterns 160A to 160D may include at least one of B, C, In, Ga, Al or a combination thereof.

In some implementations, the source/drain patterns 160A to 160D may include a compressive stress material. For example, when the active patterns A1 to A4 are silicon patterns, the source/drain patterns 160A to 160D may include a material (for example, silicon germanium (SiGe)) having a lattice constant greater than that of silicon (Si). The compressive stress material may apply compressive stress to the active patterns A1 to A4 to improve carrier mobility in the channel region.

In some implementations, the first active pattern A1 and the second active pattern A2 may form field effect transistors of different conductivity types, and the third active pattern A3 and the fourth active pattern A4 may form field effect transistors of different conductivity types. Further, in some embodiments, the second active pattern A2 and the third active pattern A3 may form field effect transistors of the same conductivity type.

For example, the second source/drain pattern 160B and the third source/drain pattern 160C may contain impurities of a first conductivity type, and the first source/drain pattern 160A and the fourth source/drain pattern 160D may contain impurities of a second conductivity type different from the first conductivity type. For example, the second source/drain pattern 160B and the third source/drain pattern 160C may contain n-type impurities, and the first source/drain pattern 160A and the fourth source/drain pattern 160D may contain p-type impurities. For another example, the second source/drain pattern 160B and the third source/drain pattern 160C may contain p-type impurities, and the first source/drain pattern 160A and the fourth source/drain pattern 160D may contain n-type impurities.

In some implementations (e.g., as shown in FIG. 2), each of the source/drain patterns 160A to 160D may include a first epitaxial layer 162 and a second epitaxial layer 164. The first epitaxial layer 162 may be formed on the side surfaces of the active patterns A1 to A4. For example, the first epitaxial layer 162 may extend along the top surfaces of the base patterns 102, the outer surface of an internal spacer 145, and the side surfaces of the bridge patterns 111 to 113. The second epitaxial layer 164 may be stacked on the first epitaxial layer 162. The first epitaxial layer 162 may be provided as a seed layer for growing the second epitaxial layer 164.

The first epitaxial layer 162 and the second epitaxial layer 164 may contain impurities of different concentrations. For example, the first epitaxial layer 162 and the second epitaxial layer 164 may include germanium (Ge) as a compressive stress material at different concentrations. For example, when the field effect transistor including the active patterns A1 to A4 and the gate structure GS is a PFET, the germanium concentration of the second epitaxial layer 164 may be higher than the germanium concentration of the first epitaxial layer 162.

In some implementations, the internal spacer 145 may be further formed on the side surface of the gate electrode 130. The internal spacer 145 may be formed on the side surface of the gate electrode 130 between the bridge patterns 1 11 to 113. The gate electrode 130 between the bridge patterns 11 1 to 113 may be electrically separated from the source/drain patterns 160A to 160D by the gate dielectric layer 120 and the internal spacer 145. In some implementations, the internal spacer 145 may be omitted.

The internal spacer 145 may include an insulating material, for example, at least one of silicon nitride, silicon oxynitride, silicon oxycarbide, silicon boron nitride, silicon boron carbonitride, silicon oxycarbonitride, or a combination thereof, but is not limited thereto. For example, the internal spacer 145 may include a silicon nitride layer. The internal spacer 145 may include the same material as that of the gate spacer 140, or may include a material different from that of the gate spacer 140. Although it is illustrated that the thickness of the internal spacer 145 is the same as the thickness of the gate spacer 140, this is only by way of example.

The first interlayer insulating layer 172 may be formed to fill the space on the outer surface of the gate spacer 140. For example, the first interlayer insulating layer 172 may cover the field insulating layer 105 and the source/drain patterns 160A to 160D.

The second interlayer insulating layer 174 may be formed on the first interlayer insulating layer 172. For example, the second interlayer insulating layer 174 may cover the top surface of the first interlayer insulating layer 172, the top surface of the gate spacer 140, and the top surface of the gate capping layer 150.

Each of the first interlayer insulating layer 172 and the second interlayer insulating layer 174 may include, for example, at least one of silicon oxide, silicon nitride, silicon oxynitride, silicon oxycarbide, silicon boron nitride, silicon carbonitride, silicon oxycarbonitride, or a low-k material having a smaller dielectric constant than silicon oxide. The low-k material may include, for example, at least one of flowable oxide (FOX), torene silazene (TOSZ), undoped silica glass (USG), borosilica glass (BSG), phosphosilica glass (PSG), borophosphosilica glass (BPSG), plasma enhanced tetra ethyl ortho silicate (PETEOS), fluoride silicate glass (FSG), carbon doped silicon oxide (CDO), Xerogel, Aerogel, amorphous fluorinated carbon, organo silicate glass (OSG), parylene, bis-benzocyclobutene (BCB), SiLK, polyimide, a porous polymeric material, or a combination thereof, but is not limited thereto.

A plurality of front source/drain contacts FC1 to FC4 may be disposed on the top surfaces of the source/drain patterns 160A to 160D. The front source/drain contacts FC1 to FC4 may penetrate/extend through the second interlayer insulating layer 174 and the first interlayer insulating layer 172 while extending in the third direction Z, and may be connected to the upper portions of the source/drain patterns 160A to 160D. For example, the front source/drain contacts FC1 to FC4 may include the first front source/drain contact FC1 connected to the first source/drain pattern 160A, the second front source/drain contact FC2 connected to the second source/drain pattern 160B, the third front source/drain contact FC3 connected to the third source/drain pattern 160C, and the fourth front source/drain contact FC4 connected to the fourth source/drain pattern 160D.

The widths of the front source/drain contacts FC1 to FC4 may decrease toward the source/drain patterns 160A to 160D. Here, the width refers to the width on the plane (for example, XY plane) intersecting the third direction Z. This may be caused by performing an etching process for forming the front source/drain contacts FC1 to FC4 on the top surfaces of the source/drain patterns 160A to 160D.

In some implementations, the front source/drain contacts FC1 to FC4 may include a first silicide layer 182 and a first metal layer 184 that are sequentially stacked on the source/drain patterns 160A to 160D.

The first metal layer 184 may include a conductive metal, for example, at least one of cobalt (Co), titanium (Ti), tantalum (Ta), ruthenium (Ru), tungsten (W), cobalt tungsten phosphorus (CoWP), or a combination thereof, but is not limited thereto. For example, the first metal layer 184 may include a cobalt layer.

The first silicide layer 182 may be interposed between the source/drain patterns 160A to 160D and the first metal layer 184. The first silicide layer 182 may be formed by reaction of elements included in the first metal layer 184 with the source/drain patterns 160A to 160D. The first silicide layer 182 may include metal silicide, for example, at least one of nickel silicide, cobalt silicide, tungsten silicide, titanium silicide, niobium silicide, tantalum silicide, or a combination thereof, but is not limited thereto. For example, the first silicide layer 182 may include a titanium silicide layer.

The front wiring structure FS may be disposed on the top surface (or, the front surface) of the substrate 100. For example, the front wiring structure FS may be formed on the top surface of the second interlayer insulating layer 174.

The front wiring structure FS may include a plurality of front inter-wiring insulating layers 210, 220, 230, 240, 250, 260, a plurality of front wiring patterns FM1 to FM3, and a plurality of front via patterns FV1 to FV3. The front wiring patterns FM1 to FM3 may be sequentially stacked on the second interlayer insulating layer 174. The front via patterns FV1 to FV3 may connect the front wiring patterns FM1 to FM3 to each other. The front wiring patterns FM1 to FM3 and the front via patterns FV1 to FV3 may be formed in the front inter-wiring insulating layers 210 to 260. The front wiring patterns FM1 to FM3 and the front via patterns FV1 to FV3 may be insulated from each other by the front inter-wiring insulating layers 210 to 260, respectively. The number of layers, number, and arrangement of the front inter-wiring insulating layers 210 to 260, the front wiring patterns FM1 to FM3, and the front via patterns FV1 to FV3 are only examples, and are not limited to the illustrated ones.

Each of the front wiring patterns FM1 to FM3 and each of the front via patterns FV1 to FV3 may include a barrier conductive layer and a filling conductive layer. The barrier conductive layer may include a metal or metal nitride for preventing diffusion of the filling conductive layer. For example, the barrier conductive layer may include at least one of titanium (Ti), tantalum (Ta), tungsten (W), nickel (Ni), cobalt (Co), platinum (Pt), an alloy thereof, or a nitride thereof, but is not limited thereto. For example, the filling conductive layer may include at least one of aluminum (Al), copper (Cu), tungsten (W), molybdenum (Mo), cobalt (Co), ruthenium (Ru), or an alloy thereof, but is not limited thereto.

The front wiring structure FS may provide a signal line and/or a power line for various integrated circuits (for example, a field effect transistor) formed on the substrate 100. For example, the first front via pattern FV1 of the front wiring structure FS may be connected to the front source/drain contacts FC1 to FC4. Accordingly, the front wiring structure FS may be electrically connected to the source/drain patterns 160A to 160D.

In some implementations, a gate contact 185 may be formed on the gate structure GS. The gate contact 185 may be connected to the gate electrode 130 while sequentially penetrating/extending through the second interlayer insulating layer 174, the first interlayer insulating layer 172, and the gate capping layer 150. The gate contact 185 may connect the gate electrode 130 and the first front wiring pattern FM1. Accordingly, the front wiring structure FS may be electrically connected to the gate electrode 130. In some implementations, the gate contact 185 may connect the gate electrode 130 and the first front via pattern FV1.

The plurality of back source/drain contacts BC1 to BC4 may be disposed on the bottom surfaces of the source/drain patterns 160A to 160D. The back source/drain contacts BC1 to BC4 may penetrate/extend through the substrate 100 while extending in the third direction Z, and may be connected to the lower portions of the source/drain patterns 160A to 160D. For example, the back source/drain contacts BC1 to BC4 may include the first back source/drain contact BC1 connected to the first source/drain pattern 160A, the second back source/drain contact BC2 connected to the second source/drain pattern 160B, the third back source/drain contact BC3 connected to the third source/drain pattern 160C, and the fourth back source/drain contact BC4 connected to the fourth source/drain pattern 160D.

In some implementations, the back source/drain contacts BC1 to BC4 may be formed in the base patterns 102. For example, as shown in FIG. 2, the back source/drain contacts BC1 to BC4 may penetrate the base patterns 102 while extending in the third direction Z. The field insulating layer 105 may cover at least a part of the side surface of each of the back source/drain contacts BC1 to BC4. For example, as shown in FIGS. 5 to 7, the field insulating layer 105 may fill the space between the back source/drain contacts BC1 to BC4 and/or between the back source/drain contacts BC1 to BC4 and the base patterns 102.

The widths of the back source/drain contacts BC1 to BC4 may decrease toward the source/drain patterns 160A to 160D. Here, the width refers to the width on the plane (for example, XY plane) intersecting the third direction Z. This may be caused by performing an etching process for forming the back source/drain contacts BC1 to BC4 on the bottom surface of the source/drain patterns 160A to 160D.

In some implementations, the back source/drain contacts BC1 to BC4 may include a second silicide layer 192 and a second metal layer 194 that are sequentially stacked on the source/drain patterns 160A to 160D.

The second metal layer 194 may include a conductive metal, for example, at least one of cobalt (Co), titanium (Ti), tantalum (Ta), ruthenium (Ru), tungsten (W), cobalt tungsten phosphorus (CoWP), or a combination thereof, but is not limited thereto. For example, the second metal layer 194 may include a cobalt layer.

The second silicide layer 192 may be interposed between the source/drain patterns 160A to 160D and the second metal layer 194. The second silicide layer 192 may be formed by reaction of elements included in the second metal layer 194 with the source/drain patterns 160A to 160D. The second silicide layer 192 may include metal silicide, for example, at least one of nickel silicide, cobalt silicide, tungsten silicide, titanium silicide, niobium silicide, tantalum silicide, or a combination thereof, but is not limited thereto. For example, the second silicide layer 192 may include a titanium silicide layer.

The back wiring structure BS may be disposed on the bottom surface (or the back surface) of the substrate 100. For example, the back wiring structure BS may be formed on the bottom surfaces of the base patterns 102 and the bottom surface of the field insulating layer 105.

The back wiring structure BS may include a plurality of back inter-wiring insulating layers 310, 320, 340, 350, a plurality of back wiring patterns BM1 and BM2, and a plurality of back via patterns BV1 and BV2. The back wiring patterns BM1 and BM2 may be sequentially stacked on the bottom surfaces of the base patterns 102 and the bottom surface of the field insulating layer 105. The back via patterns BV1 and BV2 may connect the back wiring patterns BM1 and BM2 to each other. The back wiring patterns BM1 and BM2 and the back via patterns BV1 and BV2 may be formed in the back inter-wiring insulating layers 310 to 350. The back wiring patterns BM1 and BM2 and the back via patterns BV1 and BV2 may be insulated from each other by the back inter-wiring insulating layers 310 to 350. The number of layers, number, and arrangement of the back inter-wiring insulating layers 310 to 350, the back wiring patterns BM1 and BM2, and the back via patterns BV1 and BV2 are only examples, and are not limited to the illustrated example.

Each of the back wiring patterns BM1 and BM2 and each of the back via patterns BV1 and BV2 may include a barrier conductive layer and a filling conductive layer. The barrier conductive layer may include a metal or metal nitride for preventing diffusion of the filling conductive layer. For example, the barrier conductive layer may include at least one of titanium (Ti), tantalum (Ta), tungsten (W), nickel (Ni), cobalt (Co), platinum (Pt), an alloy thereof, or a nitride thereof, but is not limited thereto. For example, the filling conductive layer may include at least one of aluminum (Al), copper (Cu), tungsten (W), molybdenum (Mo), cobalt (Co), ruthenium (Ru), or an alloy thereof, but is not limited thereto.

The back wiring structure BS may include a plurality of power lines PW1 to PW3. The power lines PW1 to PW3 may extend side by side while being spaced apart from each other. For example, the power lines PW1 to PW3 may include the first power line PW1, the second power line PW2, and the third power line PW3 that are sequentially arranged along the second direction Y. The power lines PW1 to PW3 may each extend in the first direction X, and may be spaced apart from each other in the second direction Y.

The power lines PW1 to PW3 may extend along the bottom surface of the substrate 100. Further, the power lines PW1 to PW3 may be connected to the back source/drain contacts BC1 to BC4. For example, the first power line PW1 may be connected to the first back source/drain contact BC1, and the third power line PW3 may be connected to the fourth back source/drain contact BC4. In some implementations, the second power line PW2 may be connected to both the second back source/drain contact BC2 and the third back source/drain contact BC3. That is, the first cell region CR1 and the second cell region CR2 may share the second power line PW2.

In some implementations, a first power voltage may be applied to the first power line PW1 and the third power line PW3, and a second power voltage different from the first power voltage may be applied to the second power line PW2. For example, a source voltage Vss may be applied to the second power line PW2, and a drain voltage V_{DD} may be applied to the first power line PW1 and the third power line PW3. For another example, the drain voltage V_{DD} may be applied to the second power line PW2, and the source voltage Vss may be applied to the first power line PW1 and the third power line PW3.

The back wiring structure BS including the power lines PW1 to PW3 may provide the power delivery network (PDN) for various integrated circuits (for example, a field effect transistor) formed on the substrate 100. For example, the power voltage (e.g., the source voltage Vss or the drain voltage V_{DD}) supplied from the outside may be transmitted to the uppermost wiring (for example, the second back wiring pattern BM2) of the back wiring structure BS, and may be provided to the source/drain patterns 160A to 160D through the power lines PW1 to PW3 and the back source/drain contacts BC1 to BC4.

The second back source/drain contact BC2 may include a first side surface BC2a and a second side surface BC2b that intersect in the second direction Y and are opposite to each other. For example, the first side surface BC2a may face the third back source/drain contact BC3, and the second side surface BC2b may face the first back source/drain contact BC1.

The third back source/drain contact BC3 may include a third side surface BC3a and a fourth side surface BC3b that intersect in the second direction Y and are opposite to each other. For example, the third side surface BC3a may face the second back source/drain contact BC2, and the fourth side surface BC3b may face the fourth back source/drain contact BC4.

As shown in FIGS. 1, 5, and 6, with respect to the bottom surface of the substrate 100, the second side surface BC2b and the fourth side surface BC3b may be spaced apart from each other by a first distance DS in the second direction Y. In this case, with respect to the bottom surface of the second power line PW2, at least a part of the second power line PW2 may have a first width W1 smaller than the first distance DS in the second direction Y. For example, the second power line PW2 may overlap a part of the second back source/drain contact BC2 and a part of the third back source/drain contact BC3 in the third direction Z. For example, one side surface of the second power line PW2 may overlap the second back source/drain contact BC2 in the third direction Z, and the other side surface of the second power line PW2 may overlap the third back source/drain contact BC3 in the third directions Z.

In some implementations, the size of the area where the second back source/drain contact BC2 and/or the third back source/drain contact BC3 overlap the second power line PW2 may be different from the size of the area where they do not overlap the second power line PW2. For example, a central axis that bisects the second back source/drain contact BC2 in the second direction Y may be defined. In this case, one side surface of the second power line PW2 overlapping the second back source/drain contact BC2 may not be aligned with the central axis in the third direction Z.

In some implementations, the size of the area where the second back source/drain contact BC2 and/or the third back source/drain contact BC3 overlap the second power line PW2 may be greater than the size of the area where they do not overlap the second power line PW2. For example, one side surface of the second power line PW2 may overlap the second back source/drain contact BC2 between the central axis and the second side surface BC2b.

In some implementations, the widths of the back source/drain contacts BC1 to BC4 in the second direction Y may be the same as the widths of the base patterns 102 in the second direction Y. The term "same" as used herein not only means being completely identical but also includes a minute difference that may occur due to a process margin or the like. For example, as shown in FIG. 4, the base patterns 102 may include a first base pattern 1021 and a second base pattern 1022.

The first base pattern 1021 may include a fifth side surface 1021a and a sixth side surface 1021b that intersect in the second direction Y and are opposite to each other. The fifth side surface 1021a may be disposed on the same plane as the first side surface BC2a of the second back source/drain contact BC2, and the sixth side surface 1021b may be disposed on the same plane as the second side surface BC2b of the second back source/drain contact BC2.

The second base pattern 1022 may include a seventh side surface 1022a and an eighth side surface 1022b that intersect in the second direction Y and are opposite to each other. The seventh side surface 1022a may be disposed on the same plane as the third side surface BC3a of the third back source/drain contact BC3, and the eighth side surface 1022b may be disposed on the same plane as the fourth side surface BC3b of the third back source/drain contact BC3.

As shown in FIGS. 1, 3, and 4, with respect to the bottom surface of the substrate 100, the sixth side surface 1021b and the eighth side surface 1022b may be spaced apart from each other by the first distance DS in the second direction Y. In this case, with respect to the bottom surface of the second power line PW2, at least a part of the second power line PW2 may have the first width W1 smaller than the first distance DS in the second direction Y. For example, the second power line PW2 may overlap a part of the first base pattern 1021 and a part of the second base pattern 1022 in the third direction Z.

In some implementations, as shown in FIG. 7, the second power line PW2 may overlap a part of the second back source/drain contact BC2 and a part of the base patterns 102 in the third direction Z. For example, one side surface of the second power line PW2 may overlap the second back source/drain contact BC2 in the third direction Z, and the other side surface of the second power line PW2 may overlap the first base pattern 1021 in the third direction Z.

As shown in FIG. 1, in the second direction Y, the first power line PW1 may be spaced apart from the second power line PW2 by a second distance S1, and the third power line PW3 may be spaced apart from the second power line PW2 by a third distance S2. Here, the second distance S1 and the third distance S2 may be defined with respect to (e.g., be measured at) the bottom surface (or the bottom surface of the first back inter-wiring insulating layer 310) of the second power line PW2, e.g., in the second direction Y. In some implementations, the ratio of the second distance S1 to the first width W1 of the second power line PW2 and/or the ratio of the third distance S2 to the first width W1 of the second power line PW2 may be about 0.5 to about 1.2. Within the above range, process defects caused by maximum density violation of the wiring pattern may be effectively prevented. In some implementations, the ratio of the second distance S1 to the first width W1 of the second power line PW2 and/or the ratio of the third distance S2 to the first width W1 of the second power line PW2 may be about 0.8 to about 1.1. Within the above range, process defects caused by maximum density violation of the wiring pattern may be effectively prevented.

The semiconductor device according to some implementations may have a reduced voltage drop by providing a so-called backside power delivery network (BSPDN). For example, as described above, the back wiring structure BS providing the power delivery network (PDN) may be disposed on the bottom surface (or the back surface) of the substrate 100 on which an integrated circuit (e.g., a field effect transistor) is not disposed. Accordingly, compared to the case where the power delivery network (PDN) is disposed on the top surface (or the front surface) of the substrate 100, the semiconductor device according to some implementations may reduce device size and improve (e.g., reduce) voltage drop by reducing or minimizing routing crosstalk.

For connection between the backside power delivery network (BSPDN) and the integrated circuit, a contact (hereinafter, referred to as backside direct contact) that directly connects the backside power delivery network (BSPDN) and the integrated circuit has been proposed. The backside direct contact may connect the backside power delivery network (BSPDN) and the integrated circuit by a shortest path, and thus is advantageous in terms of power, performance, area, and cost (PPAC).

However, the backside direct contact may be associated with alignment with the active pattern (for example, the active patterns A1 to A4) of the integrated circuit in the vertical direction (for example, the third direction Z), and thus may impose restriction on the backside power delivery network (BSPDN). For example, for efficient power voltage transfer, a merged power rail in which adjacent cell areas share one power line may be provided. The merged power rail may be connected to all backside direct contacts of different cell areas, and thus may be formed to have a relatively large width. In this case, if the width of the merged power rail becomes too large compared to the space with another adjacent power line, it causes process defects (for example, dishing and the like) due to maximum density violation of the wiring pattern.

The semiconductor device according to some implementations may provide a more efficiently merged power rail by using the second power line PW2 having a reduced width. Specifically, as described above, the second power line PW2 may be provided as a merged power rail connected to both the backside direct contact (for example, the second back source/drain contact BC2) of the first cell region CR1 and the backside direct contact (for example, the third back source/drain contact BC3) of the second cell region CR2, e.g., as shown in FIG. 5. Further, the first width W1 of the second power line PW2 may be smaller than the first distance DS with respect to the bottom surface of the second power line PW2, and the width may be reduced to be similar to the spacing (for example, the second distance S1 or the third distance S2) to another adjacent power line. Accordingly, process defects caused by maximum density violation of the wiring pattern may be prevented, thereby providing a semiconductor device with improved power, performance, area, and cost (PPAC).

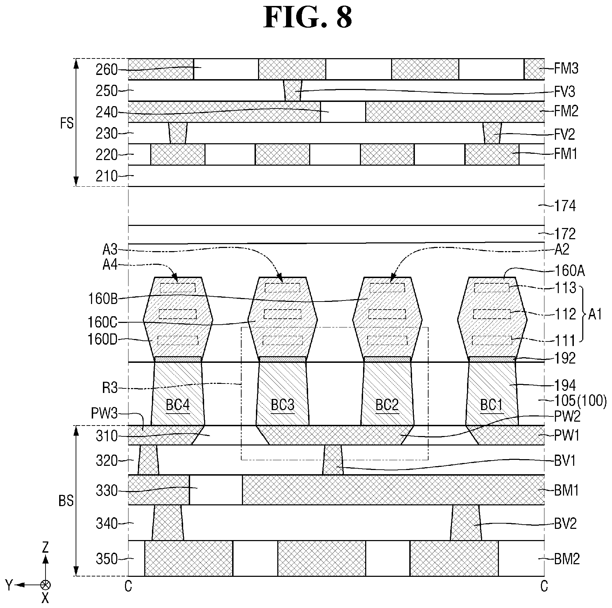

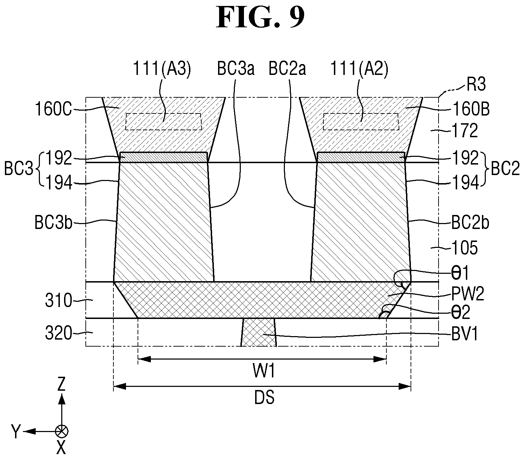

FIG. 8 is a schematic cross-sectional view illustrating a semiconductor device according to some implementations. FIG. 9 is an enlarged view illustrating region R3 of FIG. 8. For reference, FIG. 8 is another schematic cross-sectional view taken along line C-C of FIG. 1. For simplicity of description, redundant parts of the description made with reference to FIGS. 1 to 7 may be recapitulated or omitted. Except where noted otherwise, the device of FIG. 8 can have characteristics as described with respect to FIGS. 1 to 7.

Referring to FIGS. 8 and 9, in the semiconductor device according to some implementations, the widths of the power lines PW1 to PW3 may gradually increase toward the substrate 100. For example, in the second direction Y, the lengths of the top surfaces of the power lines PW1 to PW3 may be greater than the lengths of the bottom surfaces of the power lines PW1 to PW3.

For example, as shown in FIG. 9, a first internal angle θ1 formed by the top surface of the second power line PW2 and the side surface of the second power line PW2 may be an acute angle, and a second internal angle θ2 formed by the bottom surface of the second power line PW2 and the side surface of the second power line PW2 may be an obtuse angle.

Each of the power lines PW1 to PW3 may be formed by, for example, a reverse tapered etching process. Accordingly, the power lines PW1 to PW3 each having an inverted trapezoidal shape may be provided.

In some implementations, with respect to the top surface of the second power line PW2, the width of the second power line PW2 may be the same as or greater than the first distance DS (that is, greater than or equal to the first distance DS). For example, the second back source/drain contact BC2 and the third back source/drain contact BC3 may completely overlap the second power line PW2 in the third direction Z. In this case, the contact area between the second and third back source/drain contacts BC2 and BC3 and the second power line PW2 may increase, thereby providing the backside power delivery network (BSPDN) having a reduced electrical resistance.

The bottom surface of the second power line PW2 may have the first width W1 smaller than the first distance DS in the second direction Y. For example, the bottom surface of the second power line PW2 may overlap a part of the second back source/drain contact BC2 and a part of the third back source/drain contact BC3 in the third direction Z. In some implementations, the top surface of the second power line PW2 may have a width that is smaller than the first distance DS and greater than the first width W1 in the second direction Y.

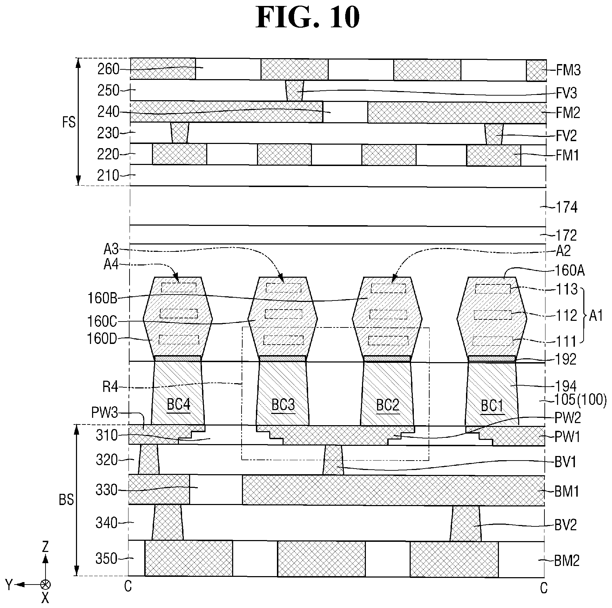

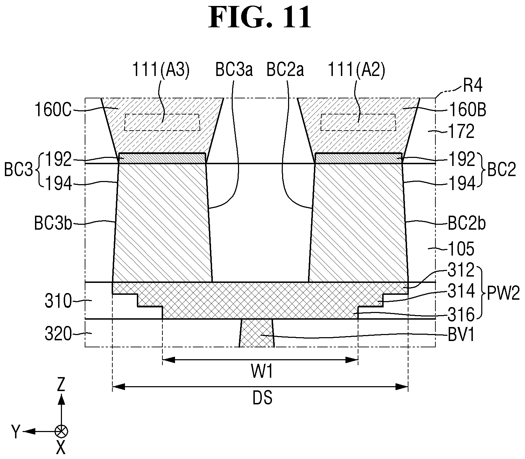

FIG. 10 is a schematic cross-sectional view illustrating a semiconductor device according to some implementations. FIG. 11 is an enlarged view illustrating region R4 of FIG. 10. For reference, FIG. 10 is a schematic cross-sectional view taken along line C-C of FIG. 1. For simplicity of description, redundant parts of the description made with reference to FIGS. 1 to 7 may be recapitulated or omitted. Except where noted otherwise, the device of FIG. 10 can have characteristics as described with respect to FIGS. 1 to 7.

Referring to FIGS. 10 and 11, in the semiconductor device according to some implementations, the widths of the power lines PW1 to PW3 may gradually decrease toward the substrate 100.

For example, as shown in FIG. 11, the second power line PW2 may include a first layer 312, a second layer 314, and a third layer 316 that are sequentially stacked on the bottom surface of the substrate 100. In the second direction Y, the width of the second layer 314 may be smaller than the width of the first layer 312, and the width of the third layer 316 may be smaller than the width of the second layer 314. The first layer 312, the second layer 314, and the third layer 316 are expressed as divided areas having different widths in the second direction Y, and they may be integrally formed.

Each of the power lines PW1 to PW3 may be formed by, for example, a staircase etching process. Accordingly, the power lines PW1 to PW3 each having a staircase shape may be provided.

In some implementations, with respect to the top surface of the second power line PW2, the width of the second power line PW2 may be greater than or equal to the first distance DS. For example, the second back source/drain contact BC2 and the third back source/drain contact BC3 may completely overlap the second power line PW2 in the third direction Z. In this case, the contact area between the second and third back source/drain contacts BC2 and BC3 and the second power line PW2 may increase, thereby providing the backside power delivery network (BSPDN) having a reduced electrical resistance.

The bottom surface of the second power line PW2 may have the first width W1 smaller than the first distance DS in the second direction Y. For example, the bottom surface of the second power line PW2 may overlap a part of the second back source/drain contact BC2 and a part of the third back source/drain contact BC3 in the third direction Z. In some implementations, the top surface of the second power line PW2 may have a width that is smaller than the first distance DS and greater than the first width W1 in the second direction Y.

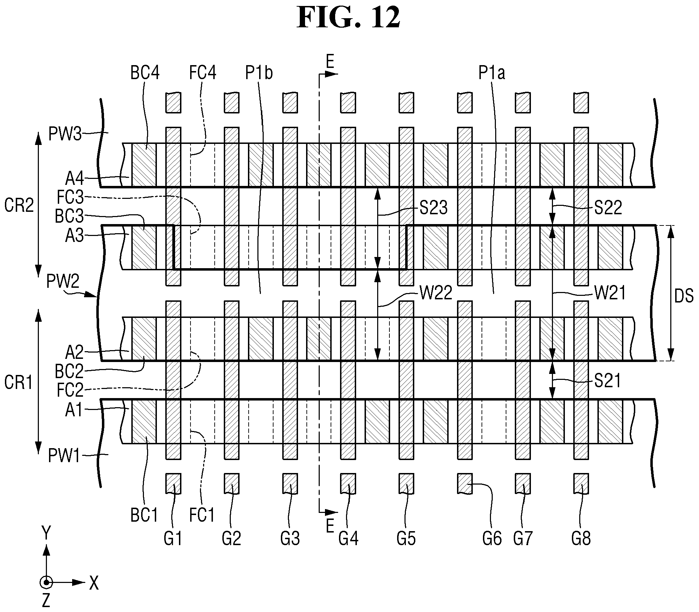

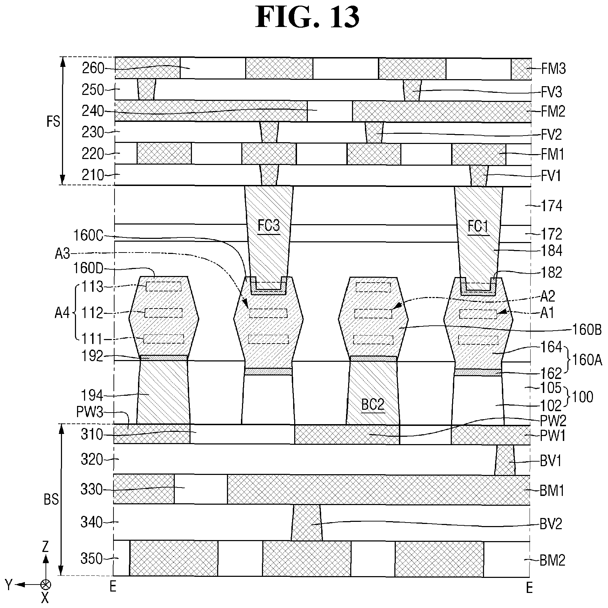

FIG. 12 is a layout diagram illustrating a semiconductor device according to some implementations. FIG. 13 is a schematic cross-sectional view taken along line E-E of FIG. 12. For simplicity of description, redundant parts of the description made with reference to FIGS. 1 to 11 may be recapitulated or omitted. Except where noted otherwise, the device of FIG. 12 can have characteristics as described with respect to FIGS. 1 to 11.

Referring to FIGS. 12 and 13, in the semiconductor device according to some implementations, the second power line PW2 may include a first portion P1a and a second portion P1b.

With respect to the bottom surface of the second power line PW2, a third width W22 of the second portion P1b may be smaller than the first distance DS. Further, the third width W22 of the second portion P1b may be smaller than a second width W21 of the first portion P1a. For example, the first power line PW1 may be spaced apart from the first portion P1a of the second power line PW2 by a fourth distance S21, and the third power line PW3 may be spaced apart from the first portion P1a of the second power line PW2 by a fifth distance S22. Further, the first power line PW1 may be spaced apart from the second portion P1b of the second power line PW2 by the fourth distance S21, and the third power line PW3 may be spaced apart from the second portion P1b of the second power line PW2 by a sixth distance S23 greater than the fifth distance S22.

In some implementations, the second width W21 of the second power line PW2 may be greater than or equal to the first distance DS.

In some implementations, the ratio of the sixth distance S23 to the third width W22 of the second power line PW2 may be about 0.5 to about 1.2. In some implementations, the ratio of the sixth distance S23 to the third width W22 of the second power line PW2 may be about 0.8 to about 1.1. Within the above ranges, process defects caused by maximum density violation of the wiring pattern may be effectively prevented.

In some implementations, the first portion P1a may overlap the second back source/drain contact BC2 and the third back source/drain contact BC3 in the third direction Z. In some implementations, one side surface of the first portion P1a may be aligned with the side surface of the second back source/drain contact BC2, and the other side surface of the first portion P1a may be aligned with the side surface of the third back source/drain contact BC3.

Further, the first portion P1a may overlap two adjacent base patterns 102 in the third direction Z. For example, the first portion P1a may overlap the base pattern 102 (for example, the first base pattern 1021 of FIG. 4) in which the second back source/drain contact BC2 is formed and the base pattern 102 (for example, the second base pattern 1022 of FIG. 4) in which the third back source/drain contact BC3 is formed. In some implementations, both side surfaces of the first portion P1a may be aligned with the side surfaces of the base patterns 102.

In some implementations, the second portion P1b may overlap the second back source/drain contact BC2 and the field insulating layer 105 in the third direction Z, and may not overlap the base pattern 102 (for example, the second base pattern 1022 of FIG. 4) in which the third back source/drain contact BC3 is formed. In some implementations, one side surface of the second portion P1b may be aligned with the side surface of the second back source/drain contact BC2, and the other side surface of the second portion P1b may be aligned with the side surface of the base pattern 102 facing the second back source/drain contact BC2. In some implementations, the other side surface of the second portion P1b may not be aligned with the side surface of the base pattern 102 facing the second back source/drain contact BC2.

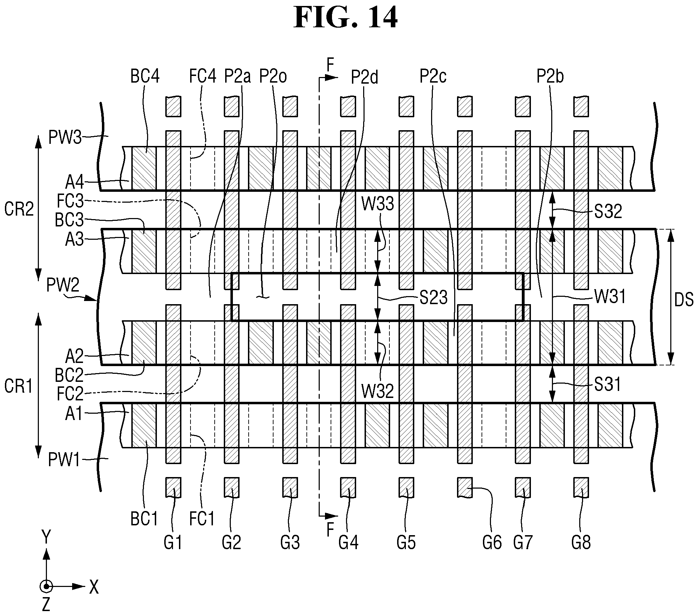

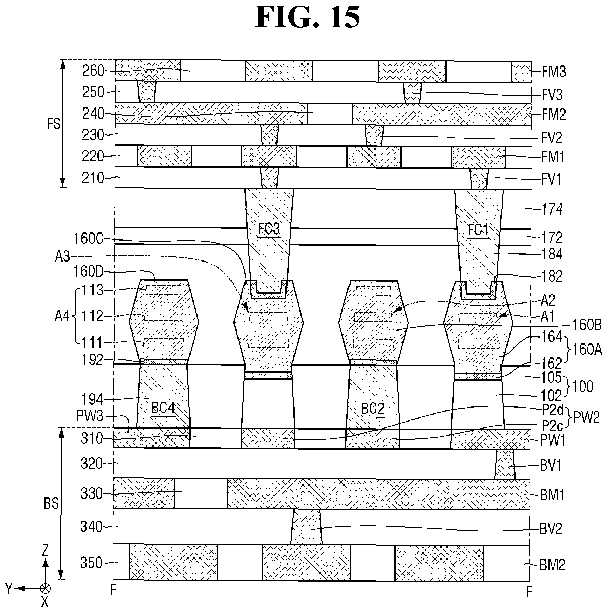

FIG. 14 is a layout diagram illustrating a semiconductor device according to some implementations. FIG. 15 is a schematic cross-sectional view taken along line F-F of FIG. 14. For simplicity of description, redundant parts of the description made with reference to FIGS. 1 to 11 may be recapitulated or omitted. Except where noted otherwise, the device of FIG. 14 can have characteristics as described with respect to FIGS. 1 to 11.

Referring to FIGS. 14 and 15, in the semiconductor device according to some implementations, the second power line PW2 may include third to sixth portions P2a to P2d.

The fifth portion P2c and the sixth portion P2d may each extend in the first direction X to connect the third portion P2a and the fourth portion P2b. Further, the fifth portion P2c and the sixth portion P2d may be spaced apart from each other in the second direction Y. In some implementations, the second power line PW2 may include a first opening P2o defined by the third to sixth portions P2a to P2d. The first opening P2o may extend in the first direction X.

With respect to the bottom surface of the second power line PW2, a fifth width W32 of the fifth portion P2c and a sixth width W33 of the sixth portion P2d may be smaller than the first distance DS. Further, the fifth width W32 of the fifth portion P2c and the sixth width W33 of the sixth portion P2d may be smaller than a fourth width W31 of the third and fourth portions P2a and P2b. For example, the first power line PW1 may be spaced apart from the second power line PW2 by a seventh distance S31, and the third power line PW3 may be spaced apart from the second power line PW2 by an eighth distance S32. Further, the fifth portion P2c of the second power line PW2 and the sixth portion P2d of the second power line PW2 may be spaced apart from each other by a ninth distance S33.

In some implementations, the fourth width W31 of the second power line PW2 may be greater than or equal to the first distance DS.

In some implementations, the ratio of the seventh distance S31 and the eighth distance S32 to the fifth width W32 and the sixth width W33 of the second power line PW2 may be about 0.5 to about 1.2. In some implementations, the ratio of the seventh distance S31 and the eighth distance S32 to the fifth width W32 and the sixth width W33 of the second power line PW2 may be about 0.8 to about 1.1. Within the above ranges, process defects caused by maximum density violation of the wiring pattern may be effectively prevented.

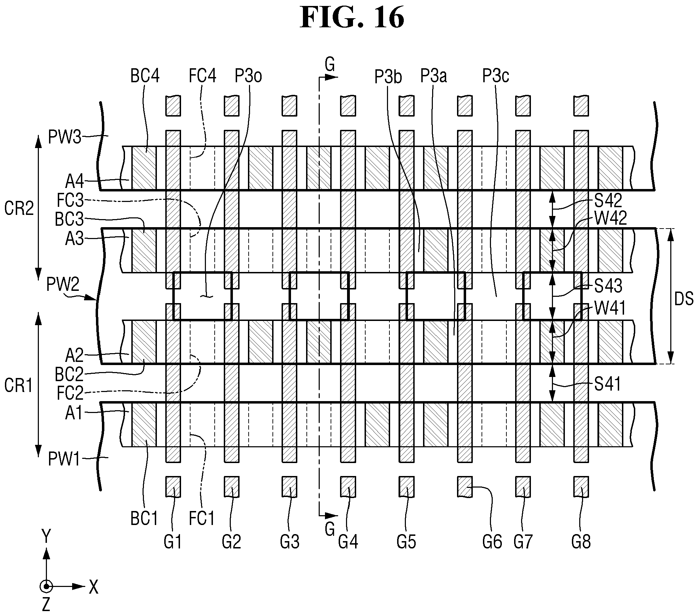

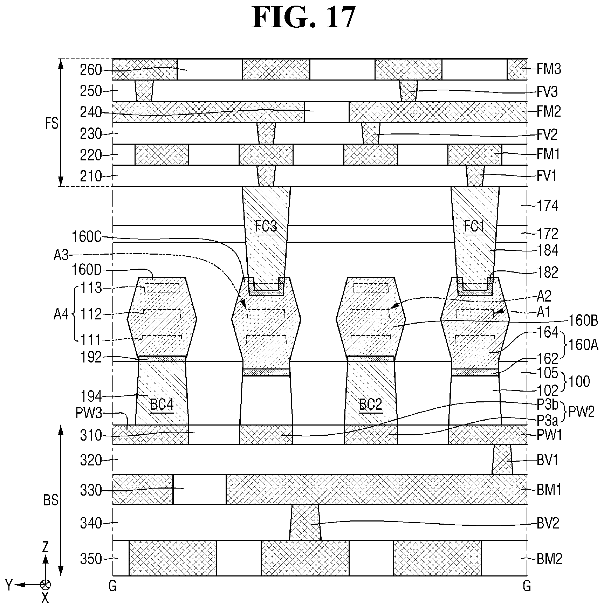

FIG. 16 is a layout diagram illustrating a semiconductor device according to some implementations. FIG. 17 is a schematic cross-sectional view taken along line G-G of FIG. 16. For simplicity of description, redundant parts of the description made with reference to FIGS. 1 to 11 may be recapitulated or omitted. Except where noted otherwise, the device of FIG. 16 can have characteristics as described with respect to FIGS. 1 to 11.

Referring to FIGS. 16 and 17, in the semiconductor device according to some implementations, the second power line PW2 may include seventh to ninth portions P3a to P3c.

The seventh portion P3a and the eighth portion P3b may each extend in the first direction X. The ninth portion P3c may extend in the second direction Y to connect the seventh portion P3a and the eighth portion P3b. In some implementations, the second power line PW2 may include a plurality of second openings P3o defined by the seventh to ninth portions P3a to P3c. The second openings P3o may be arranged along the first direction X while being spaced apart from each other by the ninth portion P3c.

With respect to the bottom surface of the second power line PW2, a seventh width W41 of the seventh portion P3a and an eighth width W42 of the eighth portion P3b may be smaller than the first distance DS. For example, the first power line PW1 may be spaced apart from the second power line PW2 by a tenth distance S41, and the third power line PW3 may be spaced apart from the second power line PW2 by an eleventh distance S42. Further, the seventh portion P3a of the second power line PW2 and the eighth portion P3b of the second power line PW2 may be spaced apart from each other by a twelfth distance S43.

In some implementations, the ratio of the tenth distance S41 and the eleventh distance S42 to the seventh width W41 and the eighth width W42 of the second power line PW2 may be about 0.5 to about 1.2. In some implementations, the ratio of the tenth distance S41 and the eleventh distance S42 to the seventh width W41 and the eighth width W42 of the second power line PW2 may be about 0.8 to about 1.1. Within the above ranges, process defects caused by maximum density violation of the wiring pattern may be effectively prevented.

In some implementations, the ratio of the twelfth distance S43 to the seventh width W41 and the eighth width W42 of the second power line PW2 may be about 0.5 to about 1.2. In some implementations, the ratio of the twelfth distance S43 to the seventh width W41 and the eighth width W42 of the second power line PW2 may be about 0.8 to about 1.1. Within the above ranges, process defects caused by maximum density violation of the wiring pattern may be effectively prevented.

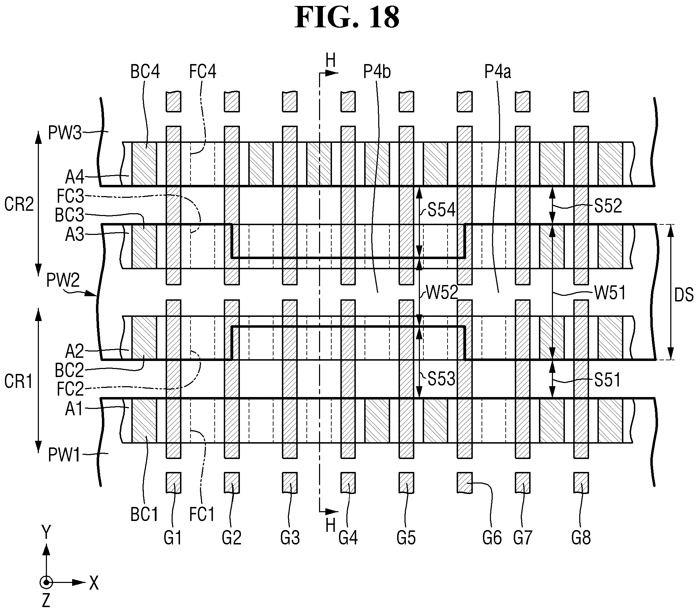

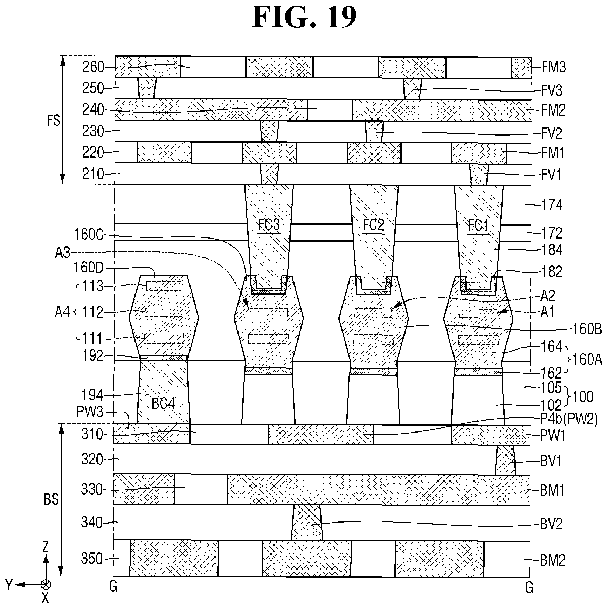

FIG. 18 is a layout diagram illustrating a semiconductor device according to some implementations. FIG. 19 is a schematic cross-sectional view taken along line H-H of FIG. 18. For simplicity of description, redundant parts of the description made with reference to FIGS. 1 to 11 may be recapitulated or omitted. Except where noted otherwise, the device of FIG. 18 can have characteristics as described with respect to FIGS. 1 to 11.

Referring to FIGS. 18 and 19, in the semiconductor device according to some implementations, the second power line PW2 may include a tenth portion P4a and an eleventh portion P4b.

With respect to the bottom surface of the second power line PW2, a tenth width W52 of the eleventh portion P4b may be smaller than the first distance DS. Further, the tenth width W52 of the eleventh portion P4b may be smaller than a ninth width W51 of the tenth portion P4a. For example, the first power line PW1 may be spaced apart from the eleventh portion P4a of the second power line PW2 by a thirteenth distance S51, and the third power line PW3 may be spaced apart from the tenth portion P4a of the second power line PW2 by a fourteenth distance S52. Further, the first power line PW1 may be spaced apart from the eleventh portion P4b of the second power line PW2 by a fifteenth distance S53 greater than the thirteenth distance S51, and the third power line PW3 may be spaced apart from the eleventh portion P4b of the second power line PW2 by a sixteenth distance S54 greater than the fourteenth distance S52.

In some implementations, the ninth width W51 of the second power line PW2 may be greater than or equal to the first distance DS.

In some implementations, the ratio of the fifteenth distance S53 and the sixteenth distance S54 to the tenth width W52 of the second power line PW2 may be about 0.5 to about 1.2. In some implementations, the ratio of the fifteenth distance S53 and the sixteenth distance S54 to the tenth width W52 of the second power line PW2 may be about 0.8 to about 1.1. Within the above ranges, process defects caused by maximum density violation of the wiring pattern may be effectively prevented.

In some implementations, the eleventh portion P4b of the second power line PW2 may not be connected to the back source/drain contacts BC1 to BC4. For example, as illustrated, the eleventh portion P4b of the second power line PW2 may not overlap the back source/drain contacts BC1 to BC4 in the third direction Z, and may overlap the front source/drain contacts FC1 to FC4.

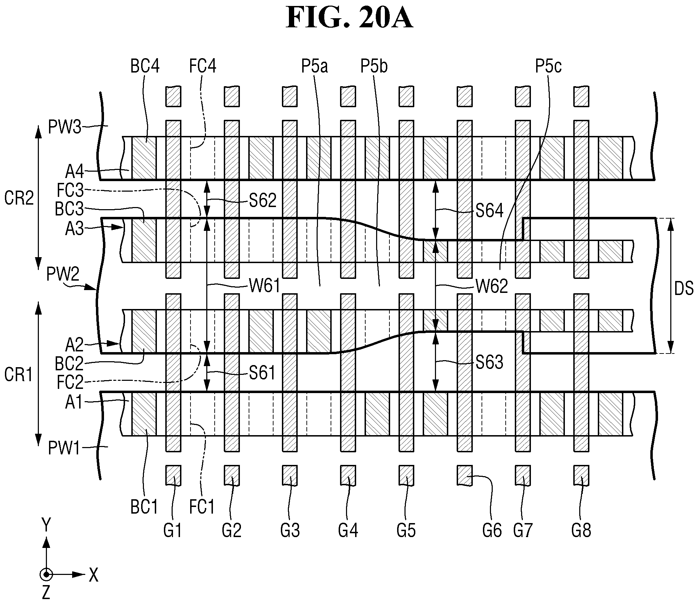

FIGS. 20A to 21B are various layout diagrams for explaining a semiconductor device according to some implementations. For simplicity of description, redundant parts of the description made with reference to FIGS. 1 to 19 may be recapitulated or omitted. Except where noted otherwise, the devices of FIGS. 20A to 21B can have characteristics as described with respect to FIGS. 1 to 19.

Referring to FIG. 20A, in the semiconductor device according to some implementations, the second power line PW2 may include twelfth to fourteenth portions P5a to P5c.

The twelfth to fourteenth portions P5a to P5c may be sequentially arranged along the first direction X. The thirteenth portion P5b may connect the twelfth portion P5a and the fourteenth portion P5c in the first direction X. With respect to the bottom surface of the second power line PW2, a twelfth width W62 of the fourteenth portion P5c may be smaller than an eleventh width W61 of the twelfth portion P5a. For example, the first power line PW1 may be spaced apart from the twelfth portion P5a of the second power line PW2 by a seventeenth distance S61, and the third power line PW3 may be spaced apart from the twelfth portion P5a of the second power line PW2 by an eighteenth distance S62. Further, the first power line PW1 may be spaced apart from the fourteenth portion P5c of the second power line PW2 by a nineteenth distance S63 greater than the seventeenth distance S61, and the third power line PW3 may be spaced apart from the fourteenth portion P5c of the second power line PW2 by a twentieth distance S64 greater than the eighteenth distance S62.

With respect to the bottom surface of the second power line PW2, the width of the thirteenth portion P5b may gradually decrease from the twelfth portion P5a toward the fourteenth portion P5c. That is, the thirteenth portion P5b may have a tapered shape whose width decreases in the first direction X.

In some implementations, the eleventh width W61 of the second power line PW2 may be greater than or equal to the first distance DS.

In some implementations, the ratio of the nineteenth distance S63 and the twentieth distance S64 to the twelfth width W62 of the second power line PW2 may be about 0.5 to about 1.2. In some implementations, the ratio of the nineteenth distance S63 and the twentieth distance S64 to the twelfth width W62 of the second power line PW2 may be about 0.8 to about 1.1. Within the above ranges, process defects caused by maximum density violation of the wiring pattern may be effectively prevented.

In some implementations, the second active pattern A2 and/or the third active pattern A3 may have a shape corresponding to that of the second power line PW2. For example, the width of the second active pattern A2 overlapping the fourteenth portion P5c of the second power line PW2 may be smaller than the width of the second active pattern A2 overlapping the twelfth portion P5a of the second power line PW2. The portion of the second active pattern A2 overlapping the thirteenth portion P5b of the second power line PW2 may have a tapered shape whose width decreases in the first direction X. Further, for example, the width of the third active pattern A3 overlapping the fourteenth portion P5c of the second power line PW2 may be smaller than the width of the third active pattern A3 overlapping the twelfth portion P5a of the second power line PW2. Further, the portion of the third active pattern A3 overlapping the thirteenth portion P5b of the second power line PW2 may have a tapered shape whose width decreases in the first direction X.

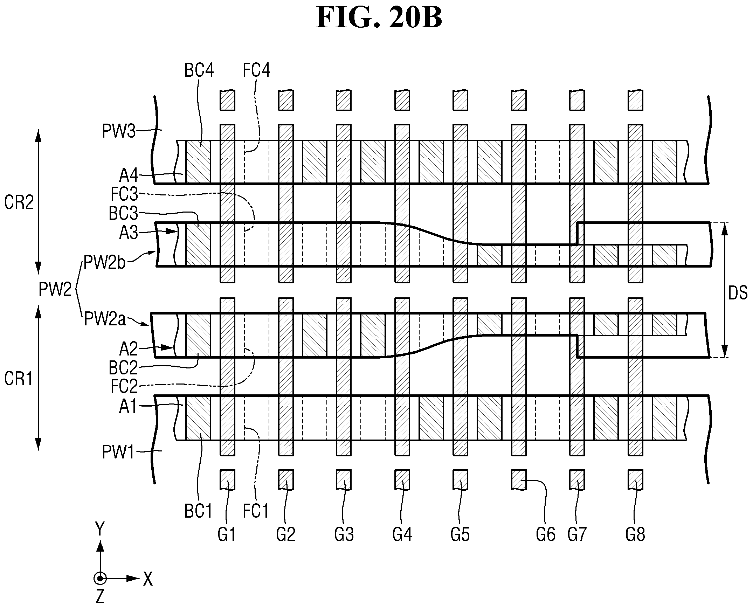

Referring to FIG. 20B, in the semiconductor device according to some implementations, the second power line PW2 may include a first sub-wiring PW2a and a second sub-wiring PW2b.

The first sub-wiring PW2a may be connected to the second back source/drain contact BC2, and the second sub-wiring PW2b may be connected to the third back source/drain contact BC3.

In some implementations, at least a part of the first sub-wiring PW2a and at least a part of the second sub-wiring PW2b may each have a tapered shape whose width decreases in the first direction X. For example, at least a part of the first sub-wiring PW2a may have a shape corresponding to that of the second active pattern A2 described above with reference to FIG. 20A, and at least a part of the second sub-wiring PW2b may have a shape corresponding to that of the third active pattern A3 described above with reference to FIG. 20A.

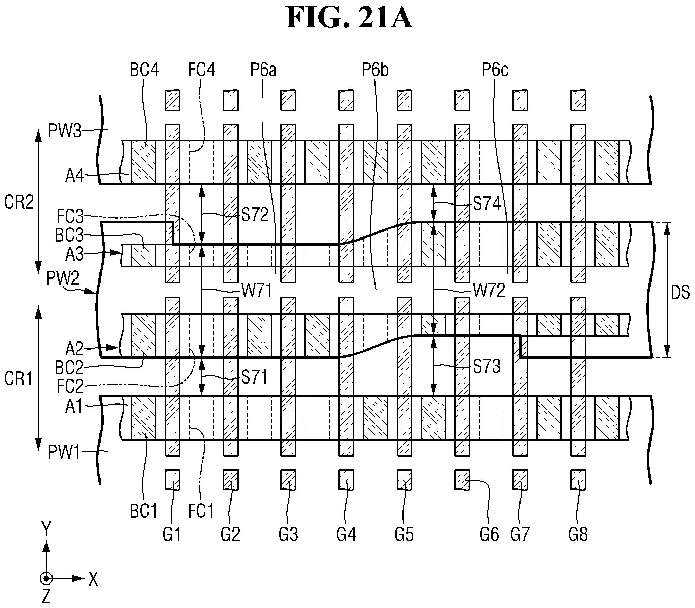

Referring to FIG. 21A, in the semiconductor device according to some implementations, the second power line PW2 may include fifteenth to seventeenth portions P6a to P6c.

The fifteenth to seventeenth portions P6a to P6c may be sequentially arranged along the first direction X. The sixteenth portion P6b may connect the fifteenth portion P6a and the seventeenth portion P6c in the first direction X. With respect to the bottom surface of the second power line PW2, the width of the sixteen portion P6b may have a bent shape. For example, the first power line PW1 may be spaced apart from the fifteenth portion P6a of the second power line PW2 by a twenty-first distance S71, and the third power line PW3 may be spaced apart from the fifteenth portion P6a of the second power line PW2 by a twenty-second distance S72. Further, the first power line PW1 may be spaced apart from the seventeenth portion P6c of the second power line PW2 by a twenty-third distance S73 greater than the twenty-first distance S71, and the third power line PW3 may be spaced apart from the seventeenth portion P6c of the second power line PW2 by a twenty-fourth distance S74 smaller than the twenty-second distance S72. In some implementations, with respect to the bottom surface of the second power line PW2, a thirteenth width W71 of the fifteenth portion P6a and a fourteenth width W72 of the seventeenth portion P6c may be the same.

In some implementations, the second active pattern A2 and/or the third active pattern A3 may have a shape corresponding to that of the second power line PW2. For example, the width of the second active pattern A2 overlapping the seventeenth portion P6c of the second power line PW2 may be smaller than the width of the second active pattern A2 overlapping the fifteenth portion P6a of the second power line PW2. The portion of the second active pattern A2 overlapping the sixteenth portion P6b of the second power line PW2 may have a tapered shape whose width decreases in the first direction X. Further, for example, the width of the third active pattern A3 overlapping the seventeenth portion P6c of the second power line PW2 may be smaller than the width of the third active pattern A3 overlapping the fifteenth portion P6a of the second power line PW2. Further, the portion of the third active pattern A3 overlapping the sixteenth portion P6b of the second power line PW2 may have a tapered shape whose width decreases in a direction -X opposite to the first direction X.

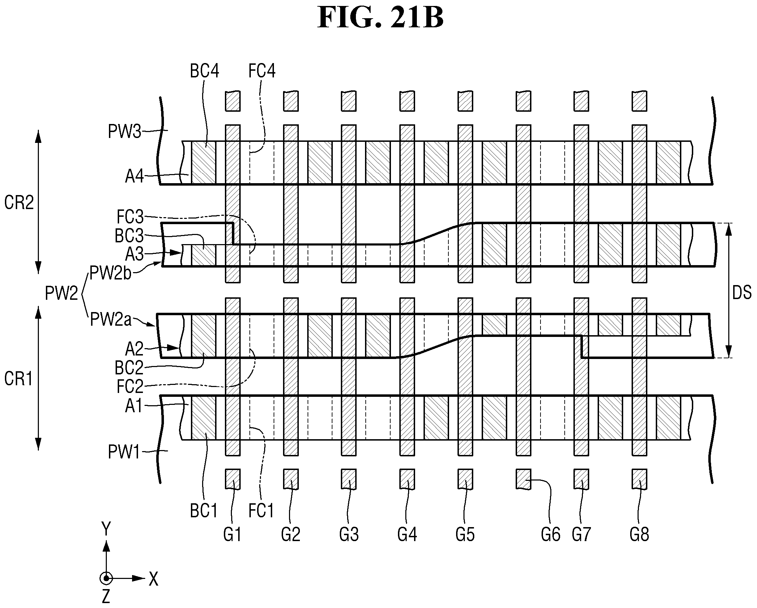

Referring to FIG. 21B, in the semiconductor device according to some implementations, the second power line PW2 may include the first sub-wiring PW2a and the second sub-wiring PW2b.

The first sub-wiring PW2a may be connected to the second back source/drain contact BC2, and the second sub-wiring PW2b may be connected to the third back source/drain contact BC3.

In some implementations, at least a part of the first sub-wiring PW2a may have a tapered shape whose width decreases in the first direction X, and at least a part of the second sub-wiring PW2b may have a tapered shape whose width decreases in the direction -X opposite to the first direction X. For example, at least a part of the first sub-wiring PW2a may have a shape corresponding to that of the second active pattern A2 described above with reference to FIG. 21A, and at least a part of the second sub-wiring PW2b may have a shape corresponding to that of the third active pattern A3 described above with reference to FIG. 21A.

Hereinafter, a method for fabricating a semiconductor device according to some implementations will be described with reference to FIGS. 1 to 39.

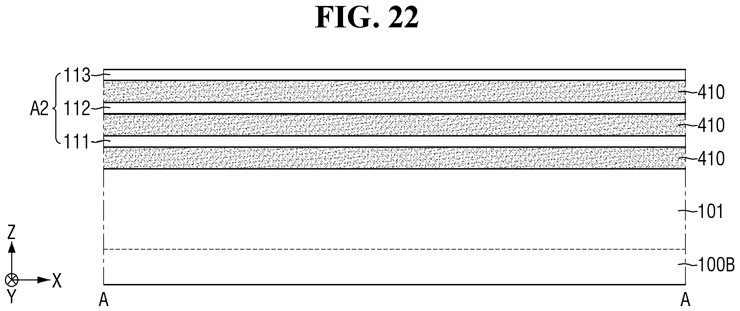

FIGS. 22 to 39 are views illustrating the intermediate steps of a method for fabricating a semiconductor device according to some implementations. For simplicity of description, redundant parts of the description made with reference to FIGS. 1 to 21B may be recapitulated or omitted.

Referring to FIG. 22, a fin pattern 101, sacrificial patterns 410, and bridge patterns 111 to 113 are formed on a base substrate 100B.

The base substrate 100B may be bulk silicon or silicon-on-insulator (SOI). Alternatively, the base substrate 100B may be a silicon substrate or may include other materials such as silicon germanium, silicon germanium on insulator (SGOI), indium antimonide, a lead tellurium compound, indium arsenide, indium phosphide, gallium arsenide, or gallium antimonide, but the present disclosure is not limited thereto. For simplicity of description, hereinafter, it is assumed that the base substrate 100B is a silicon substrate.

The base substrate 100B may include a top surface and a bottom surface opposite to each other. In this specification, the top surface of the base substrate 100B may also be referred to as a frontside, and the bottom surface of the substrate 100 may also be referred to as a backside.

The fin pattern 101 may protrude from the top surface of the base substrate 100B and extend in the first direction X. The fin pattern 101 may be a part of the base substrate 100B, and may include an epitaxial layer grown from the base substrate 100B.

The sacrificial patterns 410 and the bridge patterns 111 to 113 may be alternately stacked on the fin pattern 101. Each of the sacrificial patterns 410 and each of the bridge patterns 111 to 113 may extend in the first direction X. Accordingly, the active patterns A1 to A4 including the bridge patterns 111 to 113 that are sequentially stacked and spaced apart from each other may be provided.

The sacrificial patterns 410 may have etch selectivities different from those of the bridge patterns 111 to 113. For example, when each of the bridge patterns 111 to 113 includes a silicon (Si) layer, each of the sacrificial patterns 410 may include a silicon germanium (SiGe) layer.

The fin pattern 101, the sacrificial patterns 410, and the bridge patterns 111 to 113 may be formed by a patterning process using a mask layer extending in the first direction X as an etch mask. Although not specifically illustrated, after the fin pattern 101, the sacrificial patterns 410, and the bridge patterns 111 to 113 are formed, a field insulating layer 105 (see FIG. 3) that covers at least a part of the side surface of the fin pattern 101 may be formed.

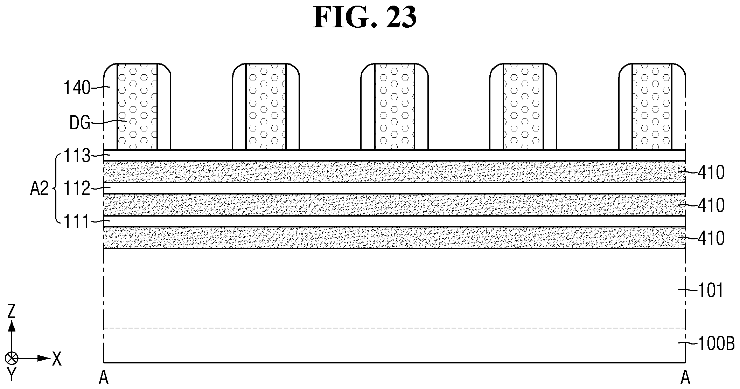

Referring to FIG. 23, a dummy gate DG and a gate spacer 140 are formed on the sacrificial patterns 410 and the bridge patterns 111 to 113.

The dummy gate DG may intersect the sacrificial patterns 410 and the bridge patterns 111 to 113. For example, the dummy gate DG may elongate in the second direction Y. The dummy gate DG may have an etch selectivity different from those of the sacrificial patterns 410 and the bridge patterns 111 to 113. For example, the dummy gate DG may include a poly silicon (poly Si) layer.

The gate spacer 140 may extend along the side surface of the dummy gate DG. The gate spacer 140 may include an insulating material, for example, at least one of silicon nitride, silicon oxynitride, silicon oxycarbide, silicon boron nitride, silicon boron carbonitride, silicon oxycarbonitride, or a combination thereof, but is not limited thereto. For example, the gate spacer 140 may include a silicon nitride layer.

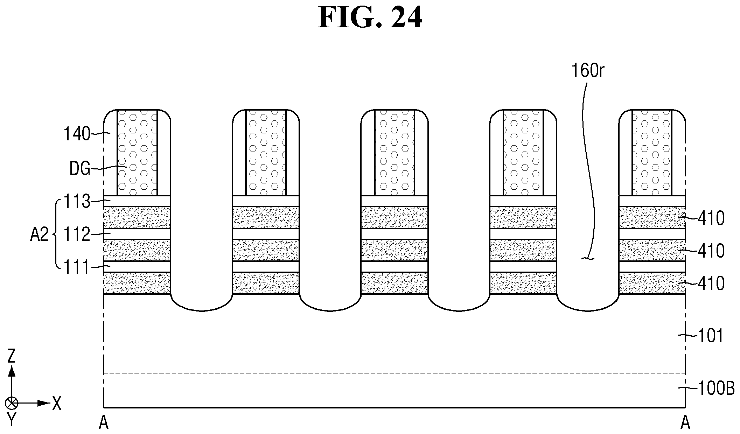

Referring to FIG. 24, a source/drain recess 160r is formed in the sacrificial patterns 410 and the bridge patterns 111 to 113 on the side surface of the dummy gate DG.

For example, a first recess process may be performed on the sacrificial patterns 410 and the bridge patterns 111 to 113 using the dummy gate DG and the gate spacer 140 as an etch mask. By performing the first recess process, a part of each of the sacrificial patterns 410 and a part of each of the bridge pattern 111 to 113 may be removed to form the source/drain recess 160r.

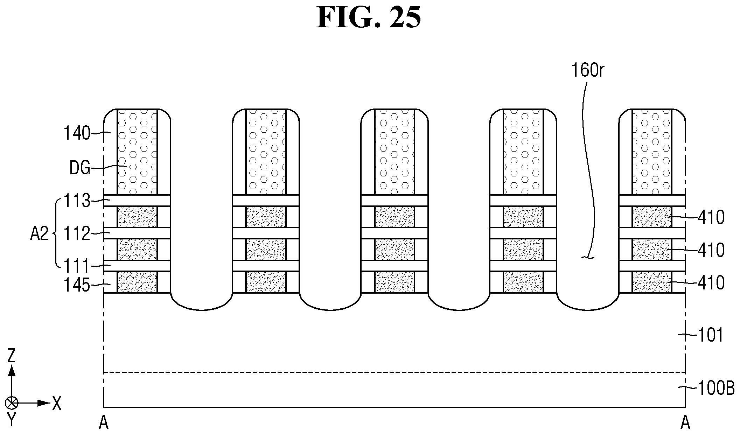

Referring to FIG. 25, an internal spacer 145 is formed on the side surface of the sacrificial patterns 410.

For example, a second recess process may be performed on the sacrificial patterns 410 exposed by the source/drain recess 160r. By performing the second recess process, the side surfaces of the sacrificial patterns 410 may be recessed. Next, the internal spacer 145 may be formed on the side surfaces of the recessed sacrificial patterns 410.

The internal spacer 145 may include an insulating material, for example, at least one of silicon nitride, silicon oxynitride, silicon oxycarbide, silicon boron nitride, silicon boron carbonitride, silicon oxycarbonitride, or a combination thereof, but is not limited thereto. For example, the internal spacer 145 may include a silicon nitride layer.

In some implementations, the formation of the internal spacer 145 may be omitted.

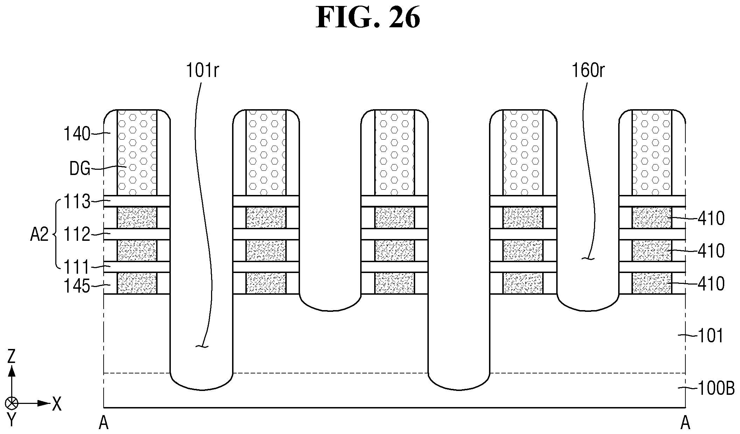

Referring to FIG. 26, a first contact recess 101r is formed in the fin pattern 101.

For example, a third recess process may be performed on at least a part of the fin pattern 101 exposed by the source/drain recess 160r. By performing the third recess process, at least a part of the fin pattern 101 may be removed to form the first contact recess 101r. The first contact recess 101r may define an area where the back source/drain contacts BC1 to BC4 to be described later are formed.

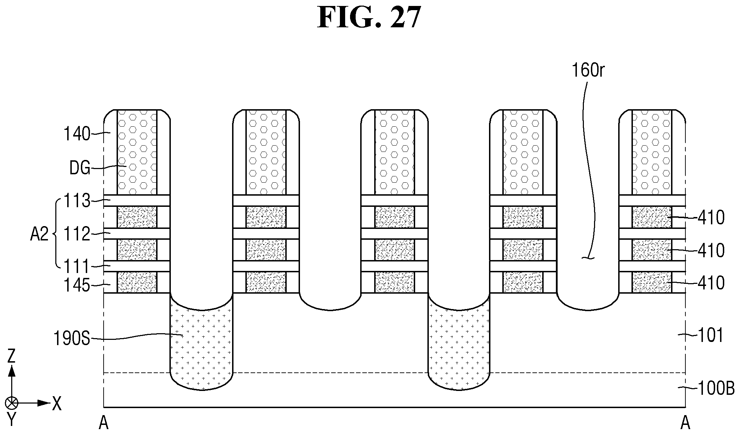

Referring to FIG. 27, a sacrificial contact 190S is formed on the base substrate 100B.

The sacrificial contact 190S may fill the first contact recess 101r of FIG. 26. The top surface of the sacrificial contact 190S may be formed lower than the bottom surface of the lowermost bridge pattern 111. For example, a sacrificial material may be deposited to fill the first contact recess 101r and the source/drain recess 160r, and an etch-back process may be performed on the sacrificial material.

The sacrificial contact 190S may have an etch selectivity different from that of the fin pattern 101. For example, when the fin pattern 101 includes a silicon (Si) layer, the sacrificial contact 190S may include a silicon germanium (SiGe) layer.

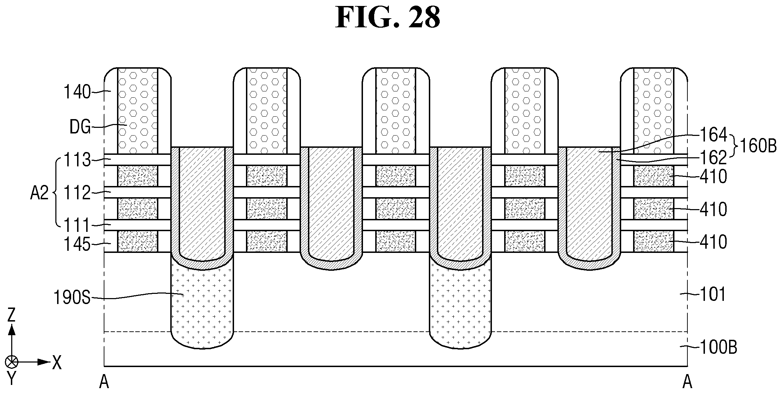

Referring to FIG. 28, the source/drain patterns 160A to 160D are formed on the fin pattern 101 and the sacrificial contact 190S.

The source/drain patterns 160A to 160D may fill the source/drain recess 160r of FIG. 27. For example, an epitaxial growth process using the fin pattern 101, the sacrificial contact 190S, and the bridge patterns 111 to 113 as seed layers may be performed. Accordingly, the source/drain patterns 160A to 160D connected to the bridge patterns 111 to 113 may be formed.

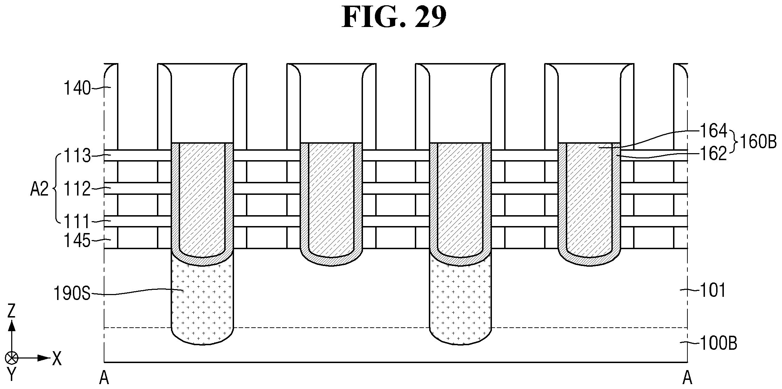

Referring to FIG. 29, the sacrificial patterns 410 and the dummy gate DG are removed.

For example, the first interlayer insulating layer 172 may be formed on the dummy gate DG, the gate spacer 140, and the source/drain patterns 160A to 160D. The first interlayer insulating layer 172 may be formed to fill the space on the outer surface of the gate spacer 140. Next, a planarization process may be performed on the first interlayer insulating layer 172 to expose the top surface of the dummy gate DG. Next, the exposed dummy gate DG may be removed. As described above, the dummy gate DG may have an etch selectivity different from those of the sacrificial patterns 410 and the bridge patterns 111 to 113, so that the dummy gate DG may be selectively removed. Since the dummy gate DG is removed, the plurality of sacrificial patterns 410 may be exposed.

Next, the plurality of exposed sacrificial patterns 410 may be removed. As described above, the sacrificial patterns 410 may have an etch selectivity different from those of the bridge patterns 111 to 113, so that the sacrificial patterns 410 may be selectively removed.

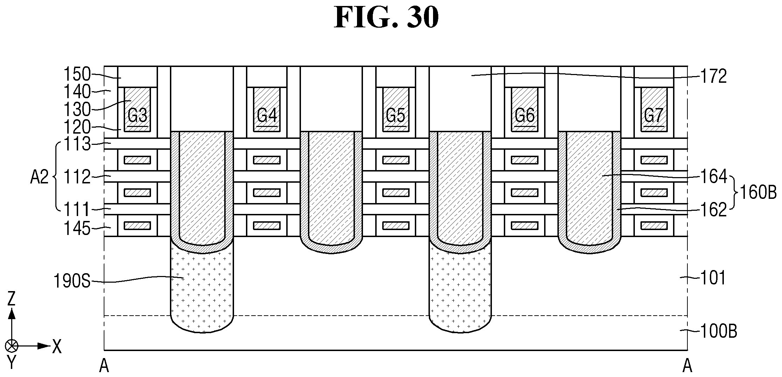

Referring to FIG. 30, the gate structures G1 to G8 are formed.

For example, the gate dielectric layer 120 and the gate electrode 130 may be sequentially stacked on the bridge patterns 111 to 113. Accordingly, the gate structures G1 to G8 intersecting the active patterns A1 to A4 may be formed to replace the dummy gate DG.

In some implementations, the upper portions of the gate structures G1 to G8 may be recessed. Next, the gate capping layer 150 may be formed on the top surfaces of the recessed gate structures G1 to G8.

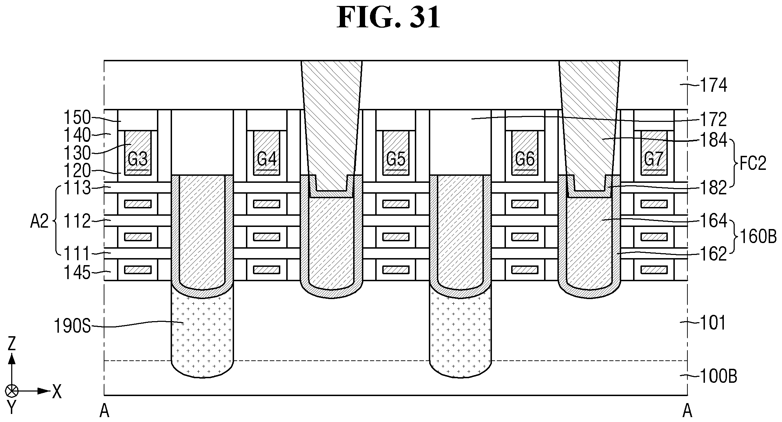

Referring to FIG. 31, the front source/drain contacts FC1 to FC4 are formed on the source/drain patterns 160A to 160D.

For example, the second interlayer insulating layer 174 that covers the first interlayer insulating layer 172, the gate spacer 140, and the gate capping layer 150 may be formed. Next, the front source/drain contacts FC1 to FC4 that are connected to the source/drain patterns 160A to 160D while penetrating the second interlayer insulating layer 174 and the first interlayer insulating layer 172 may be formed.

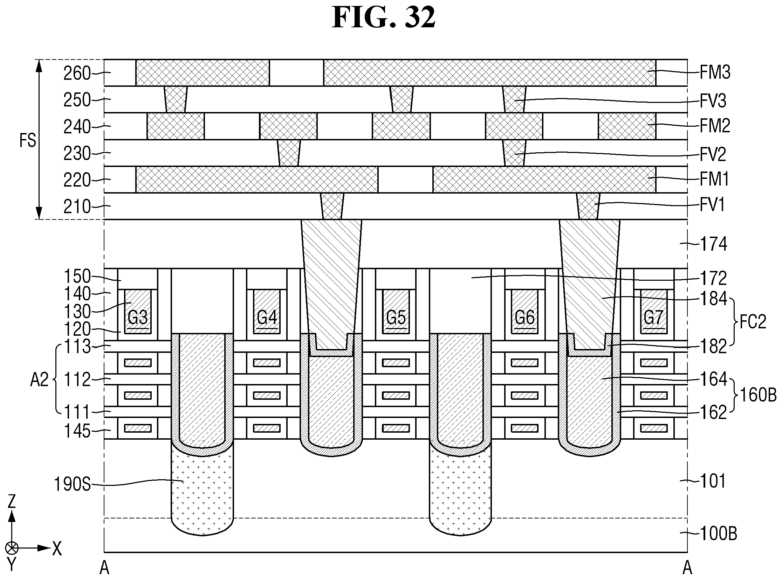

Referring to FIG. 32, the front wiring structure FS is formed on the second interlayer insulating layer 174 and the front source/drain contacts FC1 to FC4.

The front wiring structure FS may include the plurality of front inter-wiring insulating layers 210 to 260, the plurality of front wiring patterns FM1 to FM3, and the plurality of front via patterns FV1 to FV3. The front wiring structure FS may be electrically connected to the front source/drain contacts FC1 to FC4.

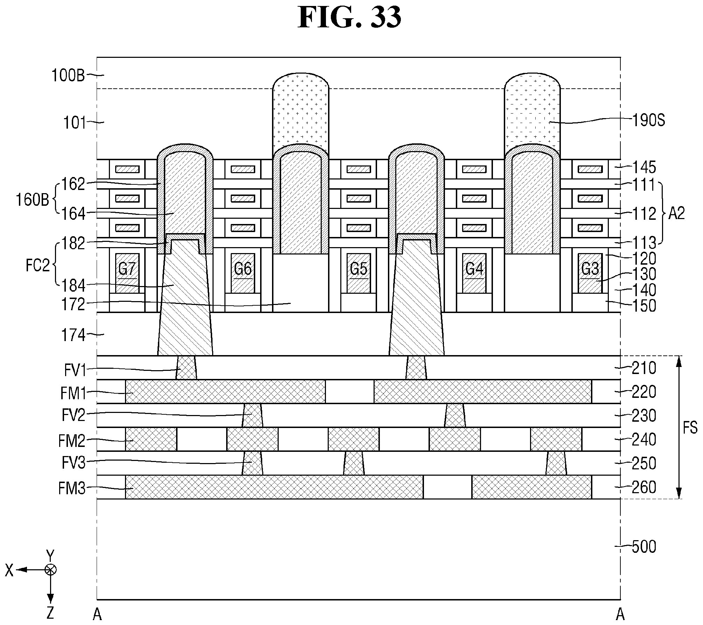

Referring to FIG. 33, the front wiring structure FS is attached onto a carrier substrate 500.

For example, the carrier substrate 500 may be attached to the resultant structure of FIG. 32. After the carrier substrate 500 is attached, the resultant structure of FIG. 32 may be inverted. For example, the backside of the base substrate 100B may face upward. In some implementations, the front wiring structure FS may be attached onto the carrier substrate 500 by an oxide-oxide bonding process.

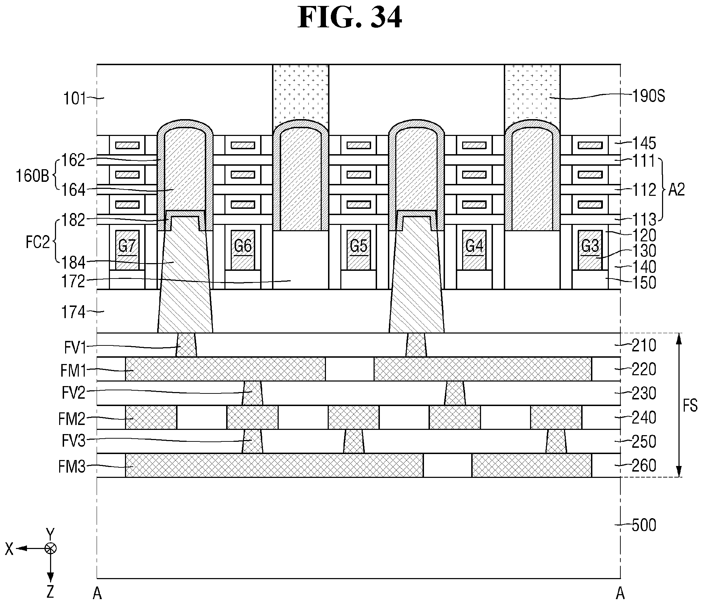

Referring to FIG. 34, the base substrate 100B is removed.

For example, a grinding process and/or a planarization process may be performed on the base substrate 100B. Since the base substrate 100B is removed, the fin pattern 101 and the sacrificial contact 190S may be exposed.

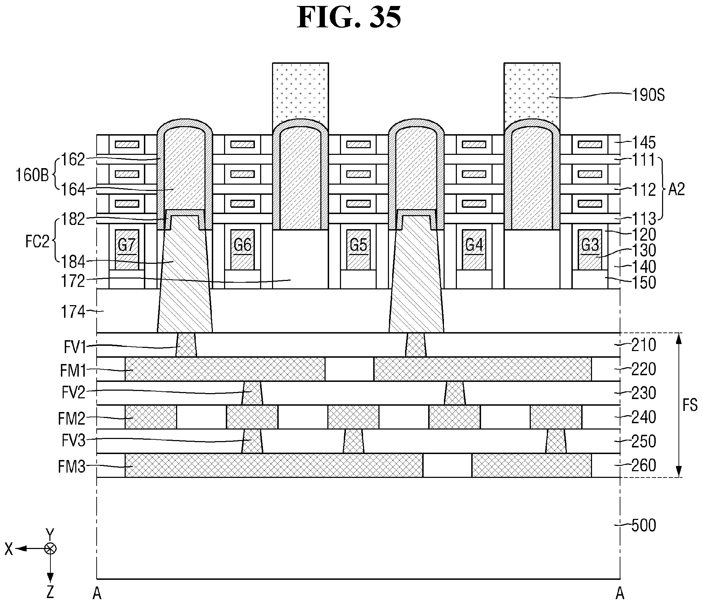

Referring to FIG. 35, the fin pattern 101 is removed.

As described above, the fin pattern 101 may have an etch selectivity different from that of the sacrificial contact 190S, so that the fin pattern 101 may be selectively removed. Since the fin pattern 101 is removed, the source/drain patterns 160A to 160D and/or the sacrificial contact 190S may be exposed. Although not specifically illustrated, during the process of removing the fin pattern 101, the field insulating layer 105 (see FIG. 3) may remain without being removed.

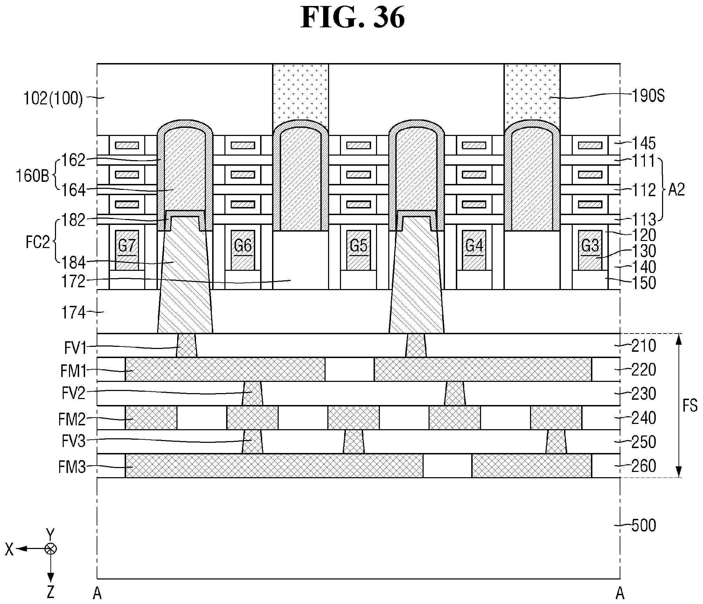

Referring to FIG. 36, the base patterns 102 are formed.

The base patterns 102 may fill the area where the fin pattern 101 has been removed. For example, the base patterns 102 may cover the source/drain patterns 160A to 160D. Further, the base patterns 102 may cover the side surface of the sacrificial contact 190S, and may expose the top surface of the sacrificial contact 190S. Accordingly, the substrate 100 including the base patterns 102 and the field insulating layer 105 may be formed.

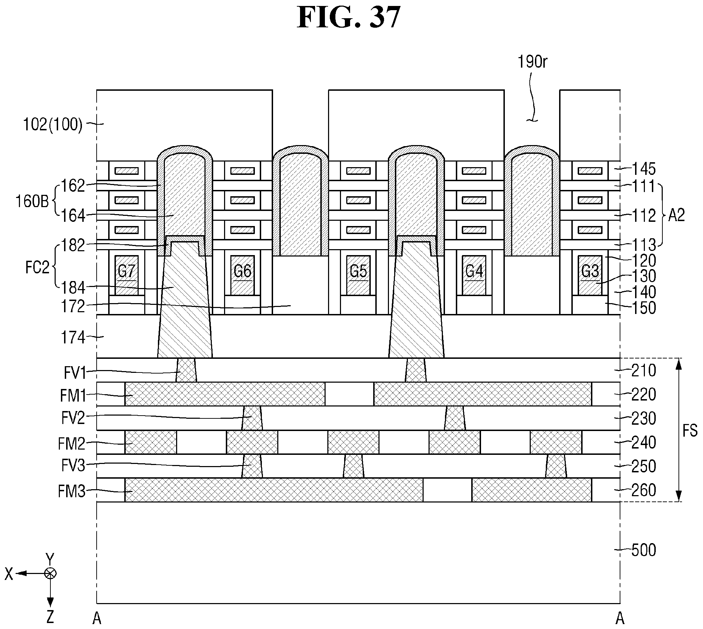

Referring to FIG. 37, the sacrificial contact 190S is removed.

The sacrificial contact 190S may be selectively removed with respect to the base patterns 102 and/or the field insulating layer 105. Since the sacrificial contact 190S is removed, a second contact recess 190r that exposes the source/drain patterns 160A to 160D in an area overlapping the sacrificial contact 190S may be formed.

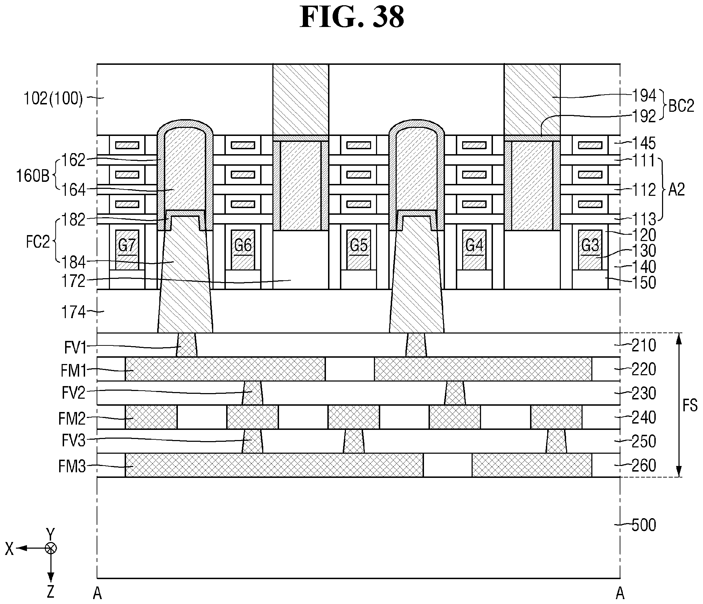

Referring to FIG. 38, the back source/drain contacts BC1 to BC4 are formed on the source/drain patterns 160A to 160D.

The back source/drain contacts BC1 to BC4 may fill the second contact recess 190r of FIG. 37. Accordingly, the back source/drain contacts BC1 to BC4 that are connected to the source/drain patterns 160A to 160D while penetrating the substrate 100 may be formed.

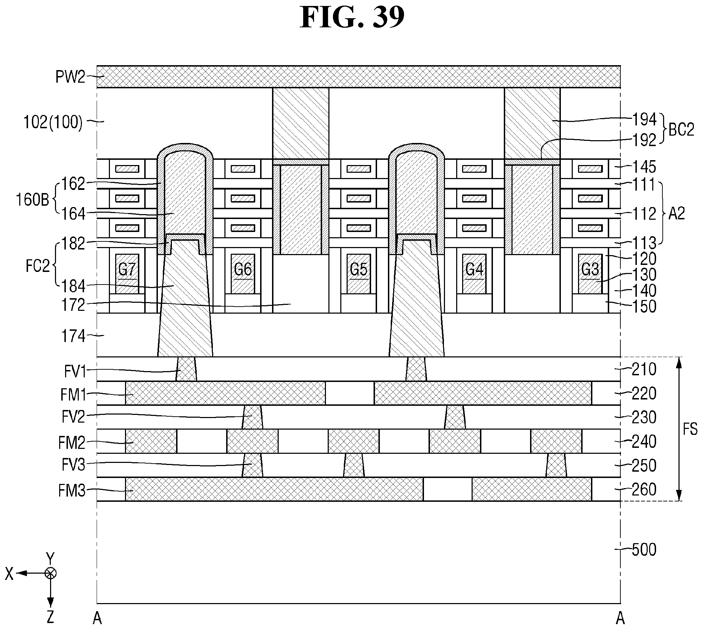

Referring to FIG. 39, the power lines PW1 to PW3 are formed on the substrate 100.

The power lines PW1 to PW3 may be electrically connected to the back source/drain contacts BC1 to BC4.

Next, referring to FIG. 2, the back wiring structure BS including the plurality of back wiring patterns BM1 and BM2 and the plurality of back via patterns BV1 and BV2 is formed. Accordingly, the semiconductor device described above with reference to FIGS. 1 to 7 may be fabricated.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While aspects of the present disclosure have been particularly shown and described with reference to implementations thereof, it will be understood by those of ordinary skill in the art that various changes in form and details may be made therein without departing from the scope of the present disclosure as defined by the following claims.

Embodiments are set out in the following clauses:
1. A semiconductor device comprising:
   a substrate;
   a first active pattern extending in a first direction on a top surface of the substrate;
   a second active pattern extending in the first direction on the top surface of the substrate and spaced apart from the first active pattern in a second direction intersecting the first direction;
   a gate structure extending in the second direction on the first active pattern and the second active pattern;
   a first source/drain pattern connected to the first active pattern and disposed on a side surface of the gate structure;
   a second source/drain pattern connected to the second active pattern and disposed on the side surface of the gate structure;
   a first back source/drain contact extending through the substrate and connected to the first source/drain pattern;
   a second back source/drain contact extending through the substrate and connected to the second source/drain pattern, wherein the second back source/drain contact is spaced apart from the first back source/drain contact in the second direction; and
   a first power line extending in the first direction on a bottom surface of the substrate and connected to the first back source/drain contact and the second back source/drain contact,
   wherein the first back source/drain contact comprises a first side surface facing the second back source/drain contact and a second side surface opposite to the first side surface,
   wherein the second back source/drain contact comprises a third side surface facing the first back source/drain contact and a fourth side surface opposite to the third side surface,
   wherein, at the bottom surface of the substrate, the second side surface and the fourth side surface are spaced apart from each other by a first distance in the second direction, and
   wherein, at a bottom surface of the first power line, at least a part of the first power line has a first width, in the second direction, smaller than the first distance.
2. The semiconductor device of clause 1, wherein the first active pattern and the second active pattern each extend in the first direction to extend through the gate structure.
3. The semiconductor device of clause 1 or 2, wherein the first source/drain pattern and the second source/drain pattern include impurities of the same conductivity type.
4. The semiconductor device of any preceding clause, wherein a width of the first back source/drain contact in the second direction and a width of the second back source/drain contact in the second direction each decrease as a distance from the first power line increases.
5. The semiconductor device of any preceding clause, further comprising a second power line extending in the first direction on the bottom surface of the substrate and spaced apart from the first power line in the second direction,
   wherein the first power line is configured to provide a first power voltage in the semiconductor device, and
   wherein the second power line is configured to provide a second power voltage, different from the first power voltage, in the semiconductor device.
6. The semiconductor device of clause 5, wherein, at the bottom surface of the first power line, the first power line and the second power line are spaced apart from each other by a second distance in the second direction, and
   wherein a ratio of the second distance to the first width is in a range from 0.5 to 1.2.
7. The semiconductor device of any preceding clause, wherein a width of the first power line in the second direction increases toward the substrate.
8. The semiconductor device of clause 7, wherein, at a top surface of the first power line, the width of the first power line in the second direction is greater than or equal to the first distance.
9. The semiconductor device of any preceding clause, wherein the first power line comprises a first portion and a second portion arranged along the first direction,
   wherein, at the bottom surface of the first power line, the first portion has the first width in the second direction, and
   wherein, at the bottom surface of the first power line, the second portion has a second width, greater than the first width, in the second direction.
10. The semiconductor device of clause 9, wherein the second width is greater than or equal to the first distance.
11. The semiconductor device of any preceding clause, further comprising:
   a first front source/drain contact on the top surface of the substrate, the first front source/drain contact connected to the first source/drain pattern; and
   a second front source/drain contact on the top surface of the substrate, the second front source/drain contact connected to the second source/drain pattern.
12. The semiconductor device of clause 11, wherein, in the second direction, the gate structure is interposed between the first back source/drain contact and the first front source/drain contact and between the second back source/drain contact and the second front source/drain contact.
13. A semiconductor device comprising:
   a first base pattern extending in a first direction;
   a second base pattern extending in the first direction and spaced apart from the first base pattern in a second direction intersecting the first direction;
   a first active pattern extending in the first direction, on a top surface of the first base pattern;
   a second active pattern extending in the first direction, on a top surface of the second base pattern;
   a gate structure extending in the second direction on the first active pattern and the second active pattern;
   a first source/drain pattern connected to the first active pattern and disposed on a side surface of the gate structure;
   a second source/drain pattern connected to the second active pattern and disposed on the side surface of the gate structure;
   a first back source/drain contact connected to the first source/drain pattern and disposed in the first base pattern;
   a second back source/drain contact connected to the second source/drain pattern and disposed in the second base pattern; and
   a first power line extending in the first direction and connected to the first back source/drain contact and the second back source/drain contact, wherein the first power line is disposed on a bottom surface of the first base pattern and a bottom surface of the second base pattern,
   wherein the first base pattern comprises a first side surface facing the second base pattern and a second side surface opposite to the first side surface,
   wherein the second base pattern comprises a third side surface facing the first base pattern and a fourth side surface opposite to the third side surface,
   wherein, at the bottom surface of the first base pattern, the second side surface and the fourth side surface are spaced apart from each other by a first distance in the second direction, and
   wherein, at a bottom surface of the first power line, at least a part of the first power line has a first width, in the second direction, smaller than the first distance.
14. The semiconductor device of clause 13, wherein the first base pattern and the second base pattern each include an insulating material.
15. The semiconductor device of clause 13 or 14, further comprising a field insulating layer covering the first, second, third, and fourth side surfaces,
   wherein the gate structure extends along the top surface of the first base pattern, the top surface of the second base pattern, and a top surface of the field insulating layer.
16. The semiconductor device of any of clauses 13 to 15, wherein a width of the first base pattern in the second direction and a width of the second base pattern in the second direction each decrease as a distance from the first power line increases.
17. The semiconductor device of any of clauses 13 to 16, wherein the first back source/drain contact and the second back source/drain contact are arranged along the second direction.
18. The semiconductor device of any of clauses 13 to 17, further comprising a second power line extending in the first direction and spaced apart from the first power line in the second direction, wherein the second power line is disposed on the bottom surface of the first base pattern and the bottom surface of the second base pattern,
   wherein the first power line is configured to provide a first power voltage in the semiconductor device, and
   wherein the second power line is configured to provide a second power voltage, different from the first power voltage, in the semiconductor device.
19. The semiconductor device of clause 18, wherein, at the bottom surface of the first power line, the first power line and the second power line are spaced apart from each other by a second distance in the second direction, and
   wherein a ratio of the second distance to the first width is in a range from 0.5 to 1.2.
20. The semiconductor device of clause 13, wherein the first power line comprises a first portion and a second portion arranged along the first direction,
   wherein, at the bottom surface of the first power line, the first portion has the first width in the second direction, and
   wherein, at the bottom surface of the first power line, the second portion has a second width, greater than the first width, in the second direction.
21. The semiconductor device of clause 20, wherein the second width is greater than or equal to the first distance.
22. The semiconductor device of any of clauses 13 to 21, further comprising:
   a first front source/drain contact connected to the first source/drain pattern and disposed on the top surface of the first base pattern; and
   a second front source/drain contact connected to the second source/drain pattern and disposed on the top surface of the second base pattern.
23. The semiconductor device of clause 22, wherein, in the second direction, the gate structure is interposed between the first back source/drain contact and the first front source/drain contact and between the second back source/drain contact and the second front source/drain contact.
24. A semiconductor device comprising:
   a substrate;
   a first active pattern, a second active pattern, and a third active pattern, each extending in a first direction on a top surface of the substrate, wherein the first, second, and third active patterns are sequentially arranged along a second direction intersecting the first direction;
   a gate structure extending in the second direction, wherein the first, second, and third active patterns each extend through the gate structure;
   a first back source/drain contact extending through the substrate and connected to a first source/drain pattern of the first active pattern;
   a second back source/drain contact extending through the substrate and connected to a second source/drain pattern of the second active pattern;
   a third back source/drain contact extending through the substrate and connected to a third source/drain pattern of the third active pattern;
   a first power line extending in the first direction on a bottom surface of the substrate and connected to the first back source/drain contact and the second back source/drain contact, wherein the first power line is configured to provide a first power voltage; and
   a second power line extending in the first direction on the bottom surface of the substrate and connected to the third back source/drain contact, wherein the second power line is configured to provide a second power voltage different from the first power voltage,
   wherein the first back source/drain contact comprises a first side surface facing the second back source/drain contact and a second side surface opposite to the first side surface,
   wherein the second back source/drain contact comprises a third side surface facing the first back source/drain contact and a fourth side surface opposite to the third side surface,
   wherein, at the bottom surface of the substrate, the second side surface and the fourth side surface are spaced apart from each other by a first distance in the second direction, and
   wherein, at a bottom surface of the first power line, at least a part of the first power line has a first width, in the second direction, smaller than the first distance.
25. The semiconductor device of clause 24, wherein the first source/drain pattern and the second source/drain pattern comprise impurities of a first conductivity type, and
   wherein the third source/drain pattern comprises impurities of a second conductivity type different from the first conductivity type.
26. The semiconductor device of clause 24 or 25, wherein, at the bottom surface of the first power line, the first power line and the second power line are spaced apart from each other by a second distance in the second direction, and
   wherein a ratio of the second distance to the first width is in a range from 0.8 to 1.1.
27. The semiconductor device of any of clauses 24 to 26, further comprising:
   a front source/drain contact connected to the first source/drain pattern and disposed on the top surface of the substrate; and
   a front wiring structure connected to the front source/drain contact and disposed on a top surface of the front source/drain contact.
28. The semiconductor device of any of clause 24 to 27, further comprising:
   a back wiring pattern on the bottom surface of the first power line and a bottom surface of the second power line; and
   a back via pattern connecting the first power line to the back wiring pattern.

## Claims

1. A semiconductor device comprising:
a substrate;
a first active pattern extending in a first direction on a top surface of the substrate;
a second active pattern extending in the first direction on the top surface of the substrate and spaced apart from the first active pattern in a second direction intersecting the first direction;
a gate structure extending in the second direction on the first active pattern and the second active pattern;
a first source/drain pattern connected to the first active pattern and disposed on a side surface of the gate structure;
a second source/drain pattern connected to the second active pattern and disposed on the side surface of the gate structure;
a first back source/drain contact extending through the substrate and connected to the first source/drain pattern;
a second back source/drain contact extending through the substrate and connected to the second source/drain pattern, wherein the second back source/drain contact is spaced apart from the first back source/drain contact in the second direction; and
a first power line extending in the first direction on a bottom surface of the substrate and connected to the first back source/drain contact and the second back source/drain contact,
wherein the first back source/drain contact comprises a first side surface facing the second back source/drain contact and a second side surface opposite to the first side surface,
wherein the second back source/drain contact comprises a third side surface facing the first back source/drain contact and a fourth side surface opposite to the third side surface,
wherein, at the bottom surface of the substrate, the second side surface and the fourth side surface are spaced apart from each other by a first distance in the second direction, and
wherein, at a bottom surface of the first power line, at least a part of the first power line has a first width, in the second direction, smaller than the first distance.

2. The semiconductor device of claim 1, wherein the first active pattern and the second active pattern each extend in the first direction to extend through the gate structure.

3. The semiconductor device of claim 1 or 2, wherein the first source/drain pattern and the second source/drain pattern include impurities of the same conductivity type.

4. The semiconductor device of any preceding claim, wherein a width of the first back source/drain contact in the second direction and a width of the second back source/drain contact in the second direction each decrease as a distance from the first power line increases.

5. The semiconductor device of any preceding claim, further comprising a second power line extending in the first direction on the bottom surface of the substrate and spaced apart from the first power line in the second direction,
wherein the first power line is configured to provide a first power voltage in the semiconductor device, and
wherein the second power line is configured to provide a second power voltage, different from the first power voltage, in the semiconductor device.

6. The semiconductor device of claim 5, wherein, at the bottom surface of the first power line, the first power line and the second power line are spaced apart from each other by a second distance in the second direction, and
wherein a ratio of the second distance to the first width is in a range from 0.5 to 1.2.

7. The semiconductor device of any preceding claim, wherein a width of the first power line in the second direction increases toward the substrate.

8. The semiconductor device of claim 7, wherein, at a top surface of the first power line, the width of the first power line in the second direction is greater than or equal to the first distance.

9. The semiconductor device of any preceding claim, wherein the first power line comprises a first portion and a second portion arranged along the first direction,
wherein, at the bottom surface of the first power line, the first portion has the first width in the second direction, and
wherein, at the bottom surface of the first power line, the second portion has a second width, greater than the first width, in the second direction.

10. The semiconductor device of claim 9, wherein the second width is greater than or equal to the first distance.

11. The semiconductor device of any preceding claim, further comprising:
a first front source/drain contact on the top surface of the substrate, the first front source/drain contact connected to the first source/drain pattern; and
a second front source/drain contact on the top surface of the substrate, the second front source/drain contact connected to the second source/drain pattern.

12. The semiconductor device of claim 11, wherein, in the second direction, the gate structure is interposed between the first back source/drain contact and the first front source/drain contact and between the second back source/drain contact and the second front source/drain contact.

13. A semiconductor device comprising:
a first base pattern extending in a first direction;
a second base pattern extending in the first direction and spaced apart from the first base pattern in a second direction intersecting the first direction;
a first active pattern extending in the first direction, on a top surface of the first base pattern;
a second active pattern extending in the first direction, on a top surface of the second base pattern;
a gate structure extending in the second direction on the first active pattern and the second active pattern;
a first source/drain pattern connected to the first active pattern and disposed on a side surface of the gate structure;
a second source/drain pattern connected to the second active pattern and disposed on the side surface of the gate structure;
a first back source/drain contact connected to the first source/drain pattern and disposed in the first base pattern;
a second back source/drain contact connected to the second source/drain pattern and disposed in the second base pattern; and
a first power line extending in the first direction and connected to the first back source/drain contact and the second back source/drain contact, wherein the first power line is disposed on a bottom surface of the first base pattern and a bottom surface of the second base pattern,
wherein the first base pattern comprises a first side surface facing the second base pattern and a second side surface opposite to the first side surface,
wherein the second base pattern comprises a third side surface facing the first base pattern and a fourth side surface opposite to the third side surface,
wherein, at the bottom surface of the first base pattern, the second side surface and the fourth side surface are spaced apart from each other by a first distance in the second direction, and
wherein, at a bottom surface of the first power line, at least a part of the first power line has a first width, in the second direction, smaller than the first distance.

14. The semiconductor device of claim 13, wherein the first base pattern and the second base pattern each include an insulating material.

15. The semiconductor device of claim 13, further comprising a field insulating layer covering the first, second, third, and fourth side surfaces,
wherein the gate structure extends along the top surface of the first base pattern, the top surface of the second base pattern, and a top surface of the field insulating layer.
